# FASCICULE DE BREVET EUROPEEN

(11) **EP 2 939 043 B1**
(45) Date de publication et mention de la délivrance du brevet: **01.02.2023**
(21) Numéro de dépôt: 13817941.1
(22) Date de dépôt: 27.12.2013
(51) Int. Cl.: G01R 33/31, G01R 33/34

(54) **DISPOSITIF ET PROCÉDÉ D'ANALYSE PAR RÉSONANCE MAGNÉTIQUE NUCLÉAIRE ET CRYOSTAT POUR CEUX-CI**
SONDE, VORRICHTUNG UND VERFAHREN ZUR KERNRESONANZMAGNETISCHEN ANALYSE
PROBE, DEVICE AND METHOD FOR NUCLEAR MAGNETIC RESONANCE ANALYSIS

(30) Priorité: 27.12.2012 FR 1262890
(43) Date de publication de la demande: 04.11.2015
(73) Titulaire: Commissariat à l'Énergie Atomique et aux Énergies Alternatives, 75015 Paris (FR)
(72) Inventeur: BOULEAU, Eric, F-38360 Sassenage (FR); DE PAËPE, Gaël, F-38500 Voiron (FR)
(74) Mandataire: Novaimo
(86) Numéro de dépôt international: PCT/EP2013/078082
(87) Numéro de publication internationale: WO 2014/102349

(56) Documents cités:
- US-A1- 2005 262 851
- US-A1- 2006 096 301
- US-A1- 2006 097 146
- MARTIN R.W.; ZILM K.W.: "Variable temperature system using vortex tube cooling and fiber optic temperature measurement for low temperature magic angle spinning NMR", JOURNAL OF MAGNETIC RESONANCE, vol. 168, 27 mars 2004 (2004-03-27), pages 202-209, XP004508572,
- C L HANNON ET AL: "Modeling, Development and Testing of a Small-Scale Collins Type Cryocooler", CRYOCOOLERS 14 - INTERNATIONAL CRYOCOOLER CONFERENCE, vol. 14, 14 juin 2006 (2006-06-14), pages 477-485, XP055119448,

## Description

### DOMAINE TECHNIQUE DE L'INVENTION

La présente invention se rapporte à un dispositif d'analyse RMN. L'invention porte aussi sur un procédé de fonctionnement d'un dispositif d'analyse RMN.

### ÉTAT DE LA TECHNIQUE

Dans l'état de l'art, un dispositif à RMN comprend une sonde comportant un porte-échantillon mis en rotation dans un champ magnétique statique et exposé à un second champ magnétique perpendiculaire au premier, par exemple créé par une bobine radiofréquence, qui reçoit en retour un signal qui est analysé pour en déduire des informations sur un échantillon, notamment un échantillon solide, disposé dans le porte-échantillon. Selon une réalisation de l'état de la technique, trois flux gazeux provenant par exemple d'une même source, un container standard comme une bouteille d'hélium montée en pression, sont dirigés vers la sonde du dispositif qui comprend le porte-échantillon. Le premier flux a pour fonction de mettre en rotation ce porte-échantillon, en agissant sur les pales ou ailettes d'une turbine d'entraînement d'un rotor (ou module de rotation) qui comprend le porte-échantillon. Le second flux a pour fonction de porter l'échantillon à une certaine température, et le troisième flux crée un palier de sustentation ou guidage du rotor dans le stator.

Dans un tel dispositif à RMN, il est important de définir une architecture de sonde qui garantisse l'obtention d'une température ad-hoc au niveau du porte-échantillon pour atteindre de très basses températures souhaitées et/ou pour ne pas consommer trop d'énergie pour les refroidir.

Pour ce faire, il est connu d'avoir recours à des techniques de calorifugation des éléments constituant de tels dispositifs à RMN de sorte à les protéger du rayonnement thermique environnant et à éviter les déperditions par convection ou par rayonnement, voire par conduction.

On connaît, du document US2006/0096301 A1, un dispositif comprenant un circuit pourvu d'une vanne permettant de réguler le débit du flux de fluide circulant dans ce circuit afin de faire varier la température au niveau d'une sonde RMN.

On connaît, de l'article de MARTIN R.W. et ZILM K.W.. "Variable température system using vortex tube cooling and fiber optic température measurement for low température magic angle spinning NMR" JOURNAL OF MAGNETIC RESONANCE. vol. 168. pages 202-209, un tube vortex de type Ranque-Hilsch susceptible d'être assemblé à une sonde RMN et comprenant une vanne permettant de réguler le débit d'un fluide dans ce tube afin de faire varier la température au niveau de la sonde.

Cependant, de telles techniques restent imparfaites et insuffisantes pour maintenir les dispositifs RMN à de très basses températures.

La présente invention vise à résoudre ces problèmes résultant des inconvénients de l'état de l'art.

### DIVULGATION DE L'INVENTION

L'invention vise à fournir un dispositif d'analyse par RMN permettant de remédier aux problèmes évoqués précédemment ainsi qu'à améliorer les dispositifs connus de l'art antérieur.

En particulier, l'invention propose un dispositif d'analyse par RMN fonctionnant à très basse température en consommant peu d'énergie, et permettant de minimiser la taille de l'échangeur thermique compris dans le cryostat.

De plus, un des avantages de l'invention est de simplifier le dispositif d'analyse par RMN par rapport à la configuration comportant des compresseurs dit chauds.

Selon un premier aspect ne faisant pas partie de l'invention, une sonde d'analyse par RMN, comprend :
- un bâti ;
- un porte-échantillon comprenant un rotor, apte à recevoir un échantillon de matière à analyser ;
- un palier de guidage en rotation du porte-échantillon relativement au bâti ;
la sonde comprenant une turbine en liaison cinématique avec le rotor, la turbine ayant une géométrie telle qu'elle permet une détente isentropique d'un troisième fluide M3 qui la traverse et en ce qu'un quatrième élément de canalisation est apte à récupérer un quatrième flux gazeux M4 de fluide sortant en aval de la turbine de détente et/ou un sixième flux gazeux M6 de fluide sortant en en aval du rotor et stator du porte-échantillon.

Selon des exemples particuliers ne faisant pas partie de l'invention, la sonde comprend :
- un premier élément de canalisation d'un troisième flux gazeux M3 de fluide vers la turbine et un deuxième élément de canalisation d'un deuxième flux gazeux de fluide M2 vers le palier, le palier étant du type aérostatique ou aérodynamique, et
- un troisième élément de canalisation d'un premier flux gazeux M1 de fluide vers le porte-échantillon, ce flux ayant pour fonction de refroidir le porte-échantillon et/ou l'échantillon.

Selon un deuxième aspect ne faisant pas partie de l'invention, un dispositif d'analyse par RMN comprenant une sonde, un module de compression et un deuxième échangeur de chaleur, dans lequel des premier et deuxième flux gazeux M1, M2 cèdent, respectivement en amont du palier et du porte-échantillon, de la chaleur au quatrième M4 et/ou sixième M6 flux gazeux.

Selon des exemples particuliers ne faisant pas partie de l'invention :
- le dispositif comporte un premier échangeur de chaleur dans lequel des premier, deuxième et troisième flux gazeux M1, M2, M3 cèdent de la chaleur à un septième flux gazeux M7 ;
- le dispositif comporte un cryoréfrigérateur agencé entre les premier et deuxième échangeurs ;
- les premier et deuxième échangeurs sont des échangeurs à contre-courant entre les premier, deuxième et troisième flux gazeux M1, M2, M3 haute pression et les quatrième, sixième et septième flux gazeux M4, M6, M7 ;
- le dispositif comporte un cryostat comprenant le cryoréfrigérateur, les premier et deuxième échangeurs et notamment le module de compression ;
- le dispositif comporte un troisième échangeur de chaleur agencé à l'extérieur du cryostat, et
- le dispositif est configuré pour réaliser un cycle thermodynamique de BRAYTON.

Selon un troisième aspect, l'invention concerne un procédé d'analyse par RMN d'un échantillon solide disposé dans un porte-échantillon comprenant les étapes suivantes :
- génération de plusieurs premier, deuxième et troisième flux gazeux M1, M2, M3 haute pression à partir d'au moins un fluide gazeux M0 haute pression ;
- création d'un palier de guidage du porte-échantillon par un deuxième flux gazeux M2 haute pression refroidi, mise en rotation du porte-échantillon par un troisième flux gazeux M3 haute pression refroidi et refroidissement du porte-échantillon par un premier flux gazeux M1 haute pression refroidi, le procédé comprenant une étape de cession de chaleur par les premier et deuxième flux gazeux M1, M2 respectivement en amont du palier et du porte-échantillon, à un quatrième M4 et/ou un sixième M6 flux gazeux constitué d'un quatrième flux gazeux M4 en aval d'une turbine de détente et d'entraînement du porte-échantillon.

Avantageusement, le procédé comprend une étape de génération du quatrième flux gazeux M4 par la détente du fluide de ce troisième flux gazeux M3 haute pression dans la turbine, la détente étant isentropique, notamment dans une turbine ayant une géométrie telle qu'elle permet une détente isentropique.

Selon un quatrième aspect, l'invention concerne un dispositif d'analyse par RMN comprenant une sonde d'analyse RMN et un cryostat reliés par une ligne cryogénique, la sonde comprenant :
- un bâti ;
- un porte-échantillon comprenant un rotor, apte à recevoir un échantillon de matière à analyser ;
- un palier de guidage en rotation du porte-échantillon relativement au bâti,
la sonde comprenant en outre un module de compression et un cryoréfrigérateur disposés dans le cryostat, le cryoréfrigérateur étant en amont du module de compression, et en ce que le dispositif d'analyse comporte un premier élément de canalisation d'un troisième flux gazeux M3 de fluide vers une turbine et un deuxième élément de canalisation d'un deuxième flux gazeux de fluide M2 vers le palier, le palier étant du type aérostatique ou aérodynamique.

Selon des modes de réalisation particuliers :
- le dispositif d'analyse comprend un troisième élément de canalisation d'un premier flux gazeux M1 de fluide vers le porte-échantillon, ce flux ayant pour fonction de refroidir le porte-échantillon et/ou l'échantillon ;
- le dispositif d'analyse comprend dans le cryostat un premier échangeur de chaleur dans lequel les premier, deuxième et troisième flux gazeux M1, M2, M3 cèdent de la chaleur à un septième flux gazeux M7 ;
- le dispositif d'analyse comprend dans le cryostat un deuxième échangeur de chaleur dans lequel des premier et deuxième flux gazeux M1, M2 cèdent, respectivement en amont du palier et du porte-échantillon de la chaleur à un quatrième M4 ou sixième M6 flux gazeux constitué d'un quatrième flux gazeux M4 en aval de la turbine constituant un détendeur monté en liaison cinématique avec le porte-échantillon ;
- le cryoréfrigérateur est agencé entre les premier et deuxième échangeurs ;
- le dispositif d'analyse comprend un quatrième élément de canalisation d'un quatrième flux gazeux M4 de fluide en aval de la turbine de détente ;
- les premier et deuxième échangeurs sont des échangeurs à contre-courant entre les premier, deuxième et troisième flux gazeux M1, M2, M3 haute pression et les quatrième, sixième et septième flux gazeux M4, M6, M7 ;
- le dispositif d'analyse est configuré pour réaliser un cycle thermodynamique de BRAYTON ;
- la turbine est une turbine de détente isentropique ayant une géométrie telle qu'elle permet une détente isentropique du fluide qui la traverse, et
- le dispositif d'analyse comprend un quatrième élément de canalisation d'un sixième flux gazeux M6 de fluide en aval du rotor et stator du porte-échantillon.

Selon un cinquième aspect, les objets de l'invention sont définis par les revendications 1 à 9.

### DESCRIPTION DES FIGURES

D'autres avantages et caractéristiques de l'invention apparaîtront mieux à la lecture de la description de modes de réalisation préférés qui vont suivre, en référence aux figures ci-dessous, réalisé à titre d'exemple indicatif et non limitatif :
- la figure 1 représente un dispositif d'analyse par RMN selon un premier exemple ne faisant pas partie de l'invention ;
- la figure 2A décrit le un dispositif d'analyse par RMN selon un deuxième exemple ne faisant pas partie de l'invention ;
- la figure 2B décrit une variante du deuxième exemple ne faisant pas partie de l'invention ;
- la figure 3 représente un dispositif d'analyse par RMN selon un troisième exemple ne faisant pas partie de l'invention ;
- la figure 4 représente un dispositif d'analyse par RMN selon un quatrième exemple ne faisant pas partie de l'invention ;
- la figure 5 décrit le un dispositif d'analyse par RMN selon un cinquième exemple ne faisant pas partie de l'invention ;
- la figure 6 représente un dispositif d'analyse par RMN selon un premier mode de réalisation de l'invention ;
- la figure 7 décrit le un dispositif d'analyse par RMN selon un deuxième mode de réalisation de l'invention ;
- la figure 8 représente un dispositif d'analyse par RMN selon un troisième mode de réalisation de l'invention ;
- la figure 9 représente un schéma fonctionnel du procédé d'un dispositif d'analyse par RMN ;
- la figure 10 est un diagramme thermodynamique représentant le cycle thermodynamique mis en oeuvre dans un dispositif d'analyse par RMN ;
- la figure 11 représente un diagramme relatif au rendement isentropique ;
- la figure 12 représente un exemple de porte-échantillon, et
- les figures 13 et 14 illustrent un exemple d'échangeur utilisable dans les différents modes de réalisation de l'invention.

### MODES DE REALISATION DE L'INVENTION

Dans la description, on adoptera les notations suivantes pour :
- le premier flux gazeux : flux gazeux M1 ;
- le deuxième flux gazeux : flux gazeux M2 ;
- le troisième flux gazeux : flux gazeux M3 ;
- le quatrième flux gazeux : flux gazeux M4 ;
- le cinquième flux gazeux : flux gazeux M5 ;
- le sixième flux gazeux : flux gazeux M6 ;
- le septième flux gazeux : flux gazeux M7 ;
- le huitième flux gazeux : flux gazeux M8, et
- le neuvième flux gazeux : flux gazeux M9.

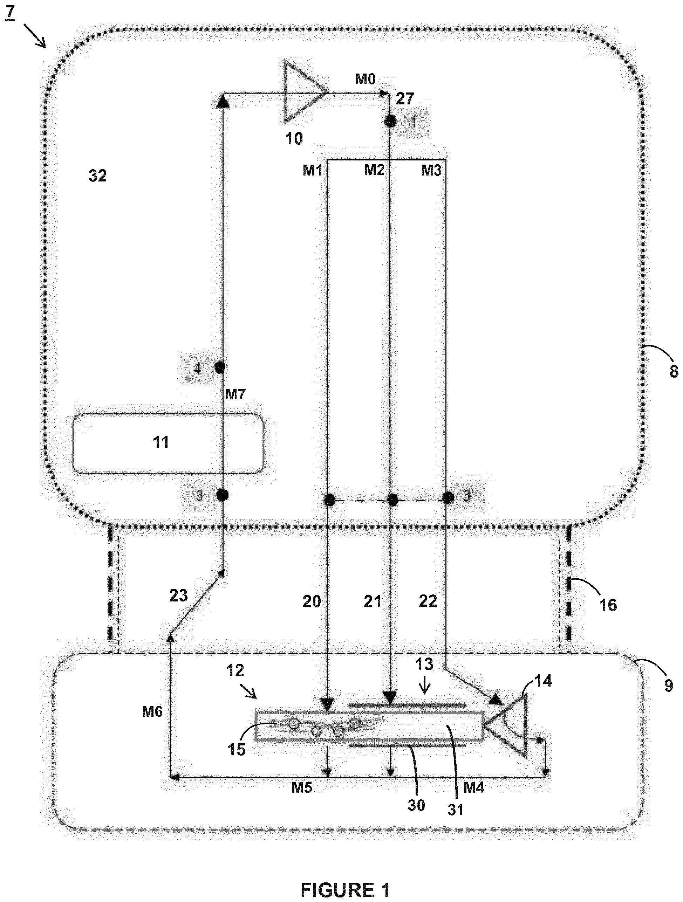

Aux figures 1 à 8, le dispositif 7 d'analyse par RMN comporte de manière non-exhaustive et non-limitative, les composants suivants :
- un module de compression 10, correspondant par exemple à au moins un compresseur de type compresseur-circulateur ;
- un cryostat 8 ;
- un cryoréfrigérateur 11, et
- une sonde 9 d'analyse par RMN.

Des composants tels qu'une ligne cryogénique 16 ou encore au moins un premier 18, un deuxième 19 et un troisième 17 échangeurs de chaleur peuvent, de manière optionnelle, être ajoutés dans ce dispositif 7 d'analyse par RMN.

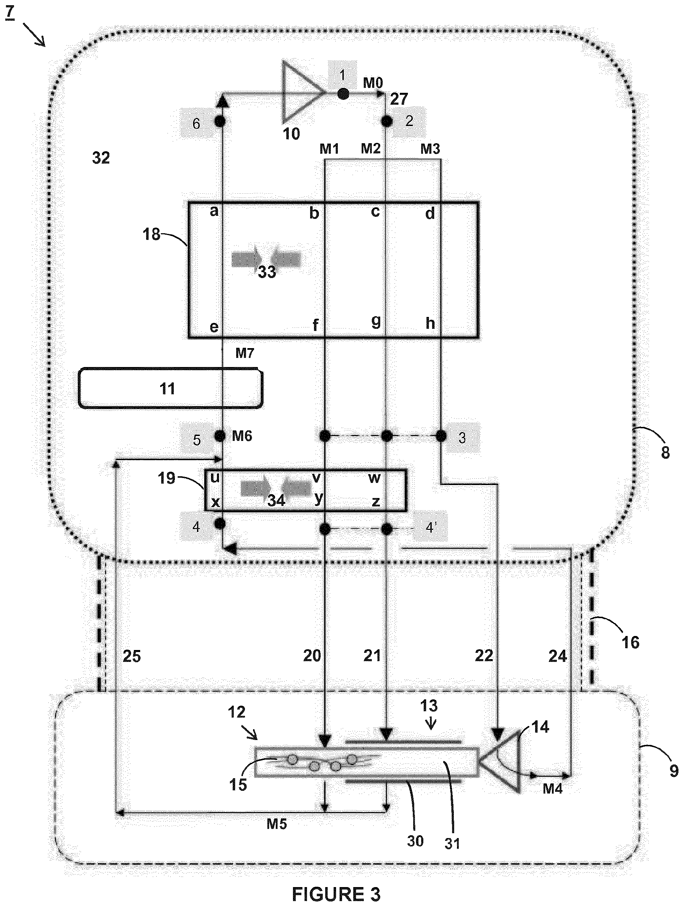

De plus, dans certains exemples de dispositif 7, notamment illustrés aux figures 3, 4 et 5, le dispositif peut comprendre une turbine 14 qui peut réaliser une détente dans un cycle thermodynamique de type de Brayton. Cette turbine entraîne en rotation le porte-échantillon 12 de la sonde 9. Cette turbine 14 est donc en liaison cinématique avec le porte-échantillon 12.

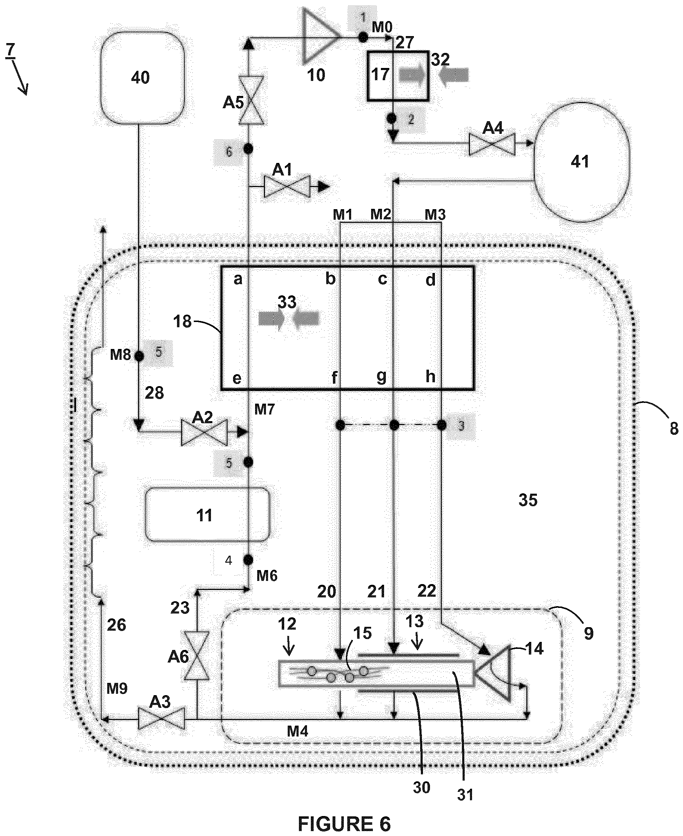

Dans certains modes de réalisation illustrés aux figures 6 à 8, d'autres composants peuvent également être agencés dans ce dispositif 7 d'analyse par RMN comme par exemple :
- des éléments de canalisation 21, 22, 23, 24, 25, 26, 27, 28, 29 ;
- des vannes A1, A2, A3, A4, A5, A6, A7, A8, A9, A10, A11 de type vannes à deux voies ;
- des éléments de redirection VC1, VC2, VC3, VC4, de type vannes cryogéniques ou encore des vannes à au moins deux voies ;
- une unité de stockage 41 de fluide haute pression, et
- une source de fluide cryogénique externe 40 comme par exemple un Dewar situé à l'extérieur du dispositif 7.

Ces différents composants du dispositif 7 d'analyse par RMN sont agencés pour former un circuit correspondant à une boucle fermée et pressurisée froide permettant d'assurer des débits moteur et réfrigérant d'un porte-échantillon 12 solide en rotation dans une sonde 9 d'analyse par RMN.

Dans ce dispositif 7 d'analyse par RMN, le module de compression 10 peut être situé dans le cryostat 8 ou hors du cryostat 8.

Ce module de compression 10 est agencé dans la boucle fermée pressurisée de sorte à assurer la circulation des fluides moteur et réfrigérant dans cette boucle.

Ce module de compression 10 a notamment pour fonction de définir le débit d'un fluide gazeux M0, lequel débit est choisi en agissant sur une vanne de régulation. La définition de ce débit permet par exemple de choisir la vitesse de rotation du porte-échantillon 12. Ce fluide gazeux M0 correspond de manière non-limitative et non-exhaustive à de l'hélium ou encore de l'azote.

Dans le circuit de ce dispositif 7, différents flux gazeux sont mis en oeuvre de sorte à décrire le parcours du fluide gazeux M0.

Ces flux gazeux sont les suivants :
- les flux gazeux M1, M2, M3 haute pression (HP) provenant de la division du fluide gazeux M0 en trois flux gazeux distincts qui vont traverser le cryostat 8 afin d'être refroidis et conduits jusqu'à la sonde 9 d'analyse par RMN ;
- le flux gazeux M4 basse pression (BP) correspondant au flux gazeux résultant du flux gazeux M3 ayant mis en rotation le porte-échantillon 12 ;
- le flux gazeux M5 basse pression (BP) correspondant aux flux gazeux résultants des flux gazeux M1, M2 ayant respectivement porté l'échantillon à une certaine température et créé un palier 13 aérostatique ou aérodynamique de sustentation ou de guidage du rotor 31 dans le stator 30 ;
- le flux gazeux M6 basse pression (BP) qui est formé par les flux gazeux M4 et M5 basse pression récupérés au niveau du rotor 31 et stator 30 du porte-échantillon 12, et
- le flux gazeux M7 basse pression correspondant aux flux gazeux résultant de la traversée par le flux gazeux M6 basse pression du cryoréfrigérateur 11.

Dans les exemples de dispositif 7 d'analyse par RMN illustrés aux figures 3, 4 et 5, lorsque ses composants sont configurés pour réaliser un cycle thermodynamique de Brayton, le flux gazeux M6 basse pression (BP) peut être formé par les flux gazeux M4 et M5 basse pression récupérés au niveau du rotor 31 et stator 30 du porte-échantillon 12 comme vu précédemment, mais il peut également être formé par le flux gazeux M5 et un flux résultant de la traversée d'au moins un échangeur de chaleur, comme le deuxième échangeur 19, par le flux gazeux M4. Lorsque le flux gazeux M6 basse pression (BP) est formé par les flux gazeux M4 et M5, le flux gazeux M7 peut résulter de la traversée du cryoréfrigérateur 11 par le flux gazeux résultant du passage du flux gazeux M6 basse pression au travers du deuxième échangeur 19 de chaleur.

Dans certains modes de réalisation illustrés aux figures 6 à 8, dans lesquels des composants tels que notamment des vannes et/ou des éléments de redirection sont agencés sur certains de ces éléments de canalisation, d'autres flux gazeux sont décrits, comme par exemple un flux gazeux M8 de fluide cryogénique émanant d'une source de fluide cryogénique 40 ainsi qu'un flux gazeux M9 qui est susceptible d'être formé par les flux gazeux M4 et M5 basse pression récupérés au niveau du rotor 31 et stator 30 du porte-échantillon 12. On notera, que dans des variantes de ces modes de réalisation, le flux gazeux M7 peut correspondre au flux gazeux M8.

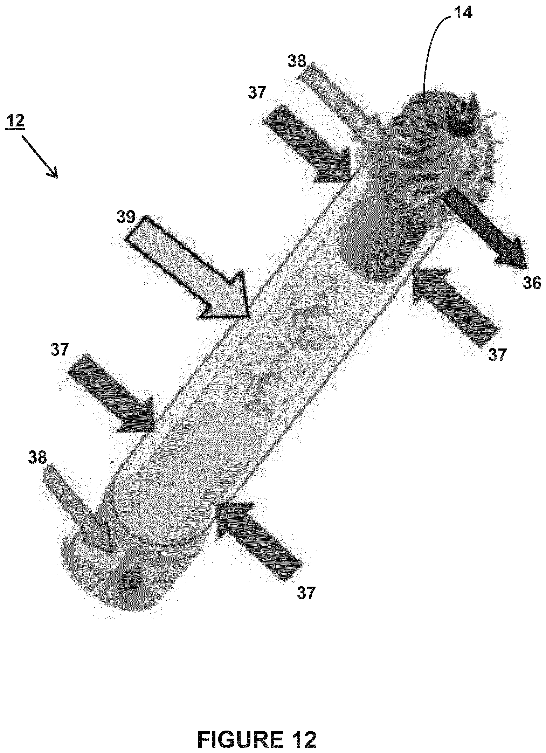

Ainsi que l'illustre la figure 12, les flux gazeux M1, M2, M3 haute pression sont susceptibles d'atteindre la sonde 9 d'analyse par RMN en étant refroidis sensiblement à la même température, et remplissent alors les fonctions suivantes :
- le flux gazeux M1 haute pression refroidit le porte-échantillon 12 et/ou l'échantillon comme le précise la flèche 39 ;
- le flux gazeux M2 haute pression assure la sustentation ou le guidage du porte-échantillon 12 tournant comme le précise les flèches 37, au niveau du palier 13 et
- le flux gazeux M3 haute pression met en rotation l'échantillon en agissant sur les pâles ou ailettes de la turbine 14 comme l'illustrent les flèches 38.

La flèche 36 illustre la production du froid au niveau de la turbine 14 configurée pour réaliser un cycle thermodynamique de Brayton. Cette turbine en plus de mettre en rotation le porte-échantillon 12, permet également d'augmenter la capacité de refroidissement du cryostat 8.

Ce dispositif 7 d'analyse par RMN comprend également un cryostat 8. Ce dernier se présente sous la forme d'une enceinte 35 à vide fermée par une platine amovible qui offre l'accès à sa partie interne. Sur cette platine, sont disposés des connecteurs d'entrée et de sortie permettant la traversée des fluides mentionnées ci-dessus ainsi que le passage de liaisons entre des dispositifs de communication de données et par exemple, une unité centrale, des capteurs de pression, de température, de fréquence du rotor, de puissance électrique.

Dans l'enceinte 35 de ce cryostat 8, un vide dynamique de l'ordre de 10⁻⁵ mbar est entretenu pour minimiser les pertes thermiques par convection et conduction gazeuses.

Tous les composants localisés à l'intérieur du cryostat 8 sont fixés mécaniquement par des pièces réalisées dans un matériau très faiblement conducteur thermique, qui limite les fuites thermiques par conduction thermique.

Ces composants sont de plus protégés du rayonnement ambiant émis par la surface interne de l'enceinte à vide, approximativement à 300K, par un écran thermique maintenu à basse température par une circulation de fluide réfrigéré suffisamment puissant pour porter l'écran thermique du cryostat 8 à une température intermédiaire entre la température ambiante de l'enceinte 35 à vide et la température la plus froide du cryostat 8.

L'enceinte 35 à vide est réalisée dans un matériau faiblement magnétique, et son écran thermique dans un matériau métallique très bon conducteur thermique.

L'isolation de l'enceinte 35 peut être obtenue par une couverture d'un super isolant tel que celle réalisée à partir de MLI, pour la dénomination anglo-saxonne de « Multi Layer Insulation ».

L'ensemble des composants compris dans le cryostat 8 est inséré dans une enceinte 35 à vide munie de traversées « étanches au vide » par lesquelles transitent les servitudes utiles au fonctionnement de la sonde (fluides, signaux d'instrumentation, puissance).

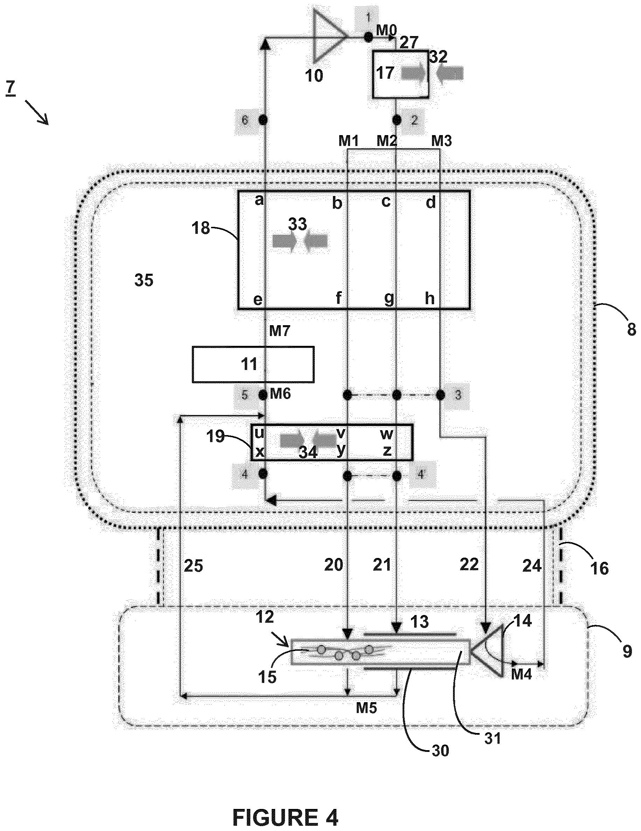

Aux figures 4 à 8, lorsque le module de compression 10 est un compresseur chaud, c'est-à-dire situé hors du cryostat 8, le cryostat 8 comprend alors au moins un échangeur de chaleur et au moins un cryoréfrigérateur 11. Alternativement, le cryostat 8 peut également comprendre en complément la sonde 9 d'analyse par RMN.

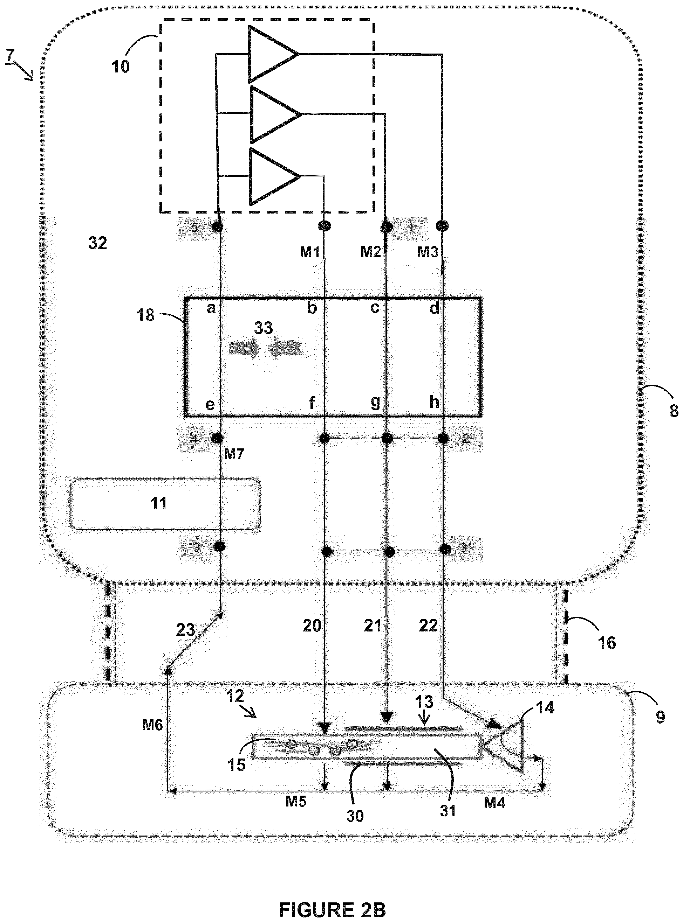

Aux figures 1 à 3, le dispositif 7 comporte un cryostat 8 comprenant le module de compression 10 et au moins un cryoréfrigérateur 11. Le module de compression 10 du dispositif 7 illustré aux figures 1, 2A et 3 est un compresseur froid tandis que celui du dispositif 7 représenté à la figure 2B correspond à trois compresseurs froids aptes à fournir chacun respectivement un des flux gazeux M1, M2, M3 haute pression (HP).

Alternativement, ce cryostat 8 peut également comprendre en complément la sonde 9 d'analyse par RMN ou au moins un échangeur de chaleur, ou encore une combinaison de ces deux composants.

Dans cette configuration du cryostat 8, la boucle pressurisée froide permet de minimiser la taille de l'échangeur de chaleur et de simplifier le dispositif 7 d'analyse par RMN par rapport à la configuration d'une boucle comportant un module de compression 10 chaud à l'extérieur de l'enceinte 35 du cryostat 8.

Dans cette configuration, où les composants de la boucle sont montés à l'intérieur de l'enceinte 35 à vide du cryostat 8, ces composants sont tous portés à température cryogénique. De plus, dans cette configuration le cryostat 8 ne comporte pas de traversées de fluides en entrées et en sorties, et il n'est pas nécessaire de réchauffer le fluide circulant dans cette boucle puisqu'il n'est pas traité par un module de compression 10 chaud installé à température ambiante à l'extérieur du cryostat 8.

Ainsi, le module de compression 10 peut correspondre dans le dispositif 7 illustré aux figures 4 à 8 à un compresseur chaud mais il peut dans des variantes correspondre dans le dispositif 7 de ces figures à trois compresseurs chauds fournissant respectivement chacun un des flux gazeux M1, M2, M3.

De même, le module de compression 10 du dispositif 7 illustré à la figure 2B peut être mis en oeuvre dans le dispositif 7 des figures 1 et 3.

Aux figures 1 à 3, le cryoréfrigérateur 11, qui est compris dans le cryostat 8, peut être agencé de diverses manières dans l'enceinte 35 de ce cryostat 8, par exemple :
- entre les premier et deuxième échangeurs 18,19 compris dans ce cryostat 8, en étant agencé en aval du deuxième échangeur 19 et en amont du premier échangeur 18 ;
- entre la sonde 9 et le premier échangeur 18, en étant agencé en aval de la sonde 9 d'analyse par RMN et en amont du premier échangeur 18, le premier échangeur 18 étant notamment compris dans l'enceinte 35 du cryostat 8, ou encore
- entre la sonde 9 et le module de compression 10, en étant agencé en aval de la sonde 9 d'analyse par RMN et en amont du module de compression 10, le module de compression 10 étant notamment compris dans l'enceinte 35 du cryostat 8.

Ce cryoréfrigérateur 11 est configuré pour qu'un quatrième élément de canalisation soit apte à conduire un flux gazeux M6 en vue de le traverser de sorte que la température de ce flux soit abaissée à une température cryogénique prédéfinie. Le fluide utilisé par le cryoréfrigérateur 11 est un fluide cryogénique basse pression, à basse température qui sert de fluide réfrigérant. Ce fluide réfrigérant peut par exemple être de l'azote ou de l'hélium.

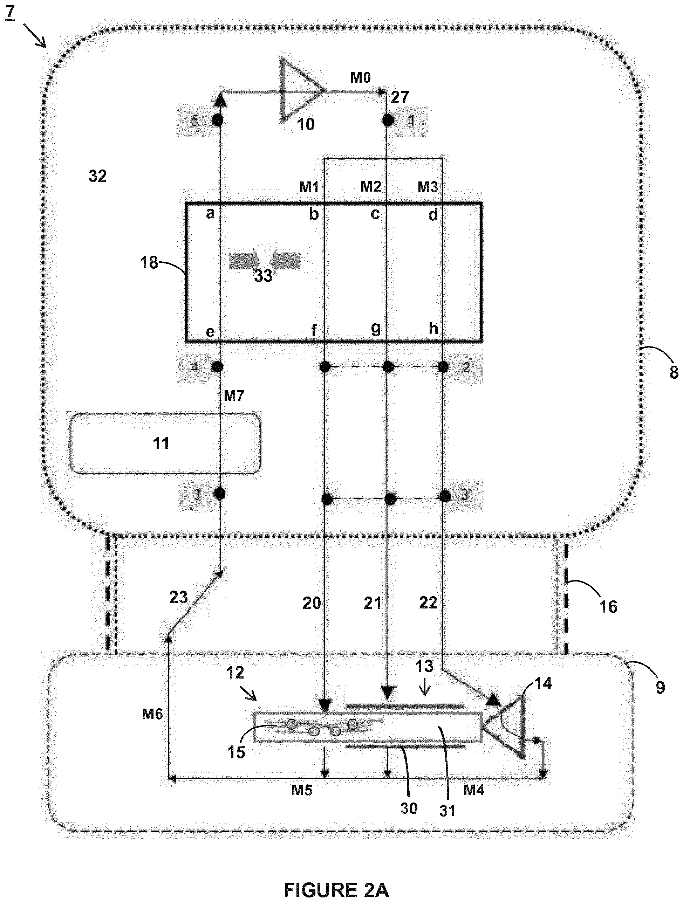

Dans certaines réalisations du dispositif 7 d'analyse par RMN illustrés aux figures 2A à 8, le cryostat 8 peut comprendre au moins un échangeur de chaleur. Dans certains de ces exemples illustrés aux figures 3 à 5 dans lesquels les composants du dispositif 7 sont configurés pour réaliser un cycle thermodynamique de Brayton, le cryostat 8 comprend par exemple deux échangeurs 11 et 18 de chaleur de type fluide/fluide tubulaire à contre-courant. Naturellement, il est évident que les échangeurs de chaleur compris dans le cryostat 8, peuvent être de tout autre nombre et de tout autre type d'échangeur de chaleur que ceux décrits.

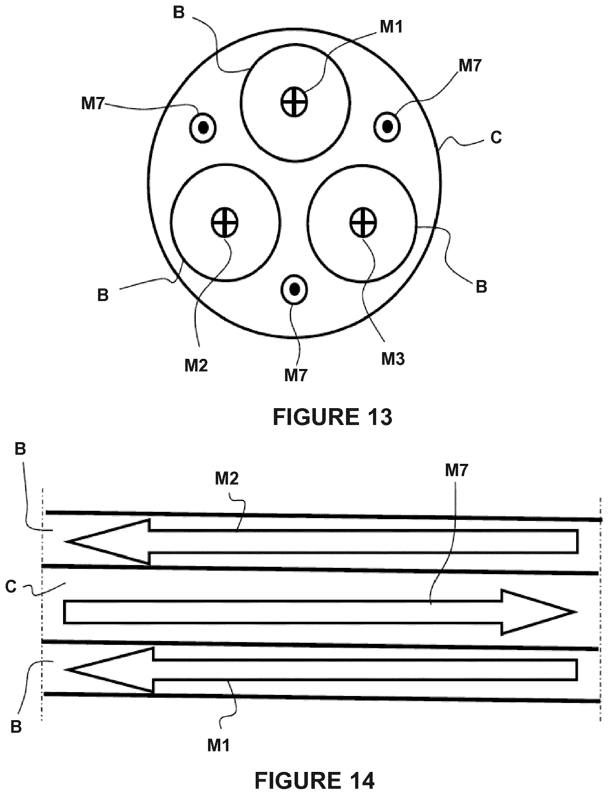

Le premier échangeur 18 de chaleur est muni de quatre entrées e, b, c, d et de quatre sorties a, f, g, h. Un tel échangeur 18 de type fluide/fluide tubulaire à contre-courant est représenté aux figures 13 et 14. Cet échangeur 18 de chaleur comprend trois tubes B haute pression pour la circulation dans une première direction des trois flux gazeux M1, M2, M3 de fluide haute pression. Ces trois tubes B sont positionnés à l'intérieur d'un grand tube C basse pression dans lequel circule un flux gazeux M7 de fluide basse pression, dans une seconde direction inverse.

Dans un tel premier échangeur 18, le transfert thermique 33 entre les deux fluides est obtenu par une convection forcée entre les flux gazeux M1, M2, M3 haute pression et la paroi de leurs tubes B haute pression respectifs, puis par conduction à travers cette paroi, avant une nouvelle convection forcée entre la surface extérieure de cette paroi des tubes B haute pression et le fluide du flux gazeux M7 basse pression.

La répartition symétrique des trois tubes B haute pression au sein du flux gazeux M7 garantit la même température de sortie pour les trois flux gazeux M1, M2, M3, toutes choses égales par ailleurs.

On notera que lorsque le dispositif 7 d'analyse par RMN comporte un échangeur tel qu'un échangeur 18 de chaleur, le module de compression 10 peut être alors agencé entre la sortie a et les entrées b, c, d, et les éléments de connexion de la sonde 9 d'analyse RMN entre les sorties f, g, h et l'entrée e.

Le deuxième échangeur 19 de chaleur est muni de trois entrées u, v, w et de trois sorties x, y, z. Le deuxième échangeur 19 de chaleur est structurellement et fonctionnellement sensiblement similaire au premier échangeur 18, à la différence près qu'il ne comporte que deux tubes haute pression pour la circulation dans une première direction de deux flux gazeux M1, M2 de fluide haute pression, au lieu de trois.

Les extrémités des tubes, du premier échangeur 18 de chaleur, peuvent être équipées d'un soufflet, pour faciliter leurs connexions avec notamment les tubes du deuxième échangeur 19. Ces soufflets permettent de plus une adaptation aux variations des dimensions des composants du dispositif 7, comme les tubes, du fait des variations importantes de température. L'ensemble est de plus spiralé pour réduire l'encombrement global du premier échangeur 18.

On notera que dans les réalisations illustrées aux figures 4 à 8, dans lesquels le dispositif 7 d'analyse par RMN comporte un module de compression 10 chaud, ces réalisations comportent un troisième échangeur 17 de chaleur agencé entre ce module du compression 10 chaud et le cryostat 8, auxquels il est relié, c'est-à-dire que ce troisième échangeur 17 est positionné en aval du module de compression 10 et en amont du cryostat 8.

Le dispositif 7 d'analyse par RMN comporte également une sonde 9 d'analyse par RMN comprenant un bâti dans lequel est agencé un porte-échantillon 12 mobile ainsi qu'un palier de guidage en rotation dudit porte-échantillon 12 relativement au bâti. Les composants de la sonde, potentiellement portés à de basses températures, sont supportés ou suspendus mécaniquement par des pièces réalisées en un matériau thermiquement isolant.

Ce porte-échantillon 12 est positionné dans la sonde 9 d'analyse par RMN de manière inclinée avec un angle ajustable compris entre des axes parallèles et perpendiculaires du champ magnétique statique.

Ce porte-échantillon 12 comporte un tube dans lequel est placé l'échantillon de matière 15 à analyser. Cet échantillon de matière 15 peut être un échantillon solide.

Ainsi que l'illustrent les figures, le porte-échantillon 12 comporte alors, un rotor 31 et un stator 30. Ce stator 30 peut comprendre en plus des paliers 13.

La turbine 14 est pourvue de pâles ou ailettes qui lorsqu'elles sont frappées par un flux gazeux M3 mettent en rotation le rotor du porte-échantillon 12. La turbine 14 utilise l'énergie cinétique comprise dans le flux gazeux M3 pour mettre en rotation le rotor du porte-échantillon 12. Ainsi, l'énergie cinétique du flux gazeux M3 est utilisée pour produire de l'énergie mécanique. Une turbine peut être agencée aux deux extrémités du rotor. La turbine 14 est montée en liaison cinématique avec le rotor porte-échantillon 12.

Le rotor peut être un tube fermé par deux bouchons, qui remplissent deux fonctions. D'une part l'étanchéité du tube et d'autre part la mise rotation du porte-échantillon 12. Chaque bouchon comprend par exemple une turbine 14.

Dans d'autres exemples de dispositif 7 d'analyse par RMN illustrés par exemple aux figures 3, 4 et 5, lorsque ses composants sont configurés pour réaliser un cycle thermodynamique de Brayton, chacun de ces bouchons correspond alors à une turbine de détente en liaison cinématique avec le rotor 31. Cette turbine de détente présente les mêmes caractéristiques et propriétés qu'un détendeur configuré pour être mis en oeuvre dans des cycles thermodynamiques de Brayton.

En effet, cette turbine de détente a une géométrie particulière qui est telle que le rendement isentropique de la détente du fluide au travers de celle-ci est supérieur à 70%, voire supérieur à 85%.

Ainsi la géométrie de cette turbine permet une détente isentropique du fluide gazeux M3 qui la traverse avec un rendement isentropique supérieur à 70%, voire supérieur à 85%. On considère comme détente isentropique une détente dont le rendement isentropique relativement à une détente purement isentropique est supérieur à 70%, voire supérieur à 85%.

De plus, cette géométrie particulière de la turbine la rend apte à abaisser la température de flux gazeux qui la traversent par exemple de :
- 15 à 10 K en fournissant une puissance de l'ordre de 50W et/ou
- 70 à 55 K en fournissant une puissance de l'ordre de 150 W.

Cette géométrie particulière peut être obtenue par usinage dans la masse des bouchons évoqués précédemment, de pâles ou d'ailettes dont l'agencement et les caractéristiques visent à provoquer la détente de type isentropique du flux gazeux M3 de fluide qui les traverse. Une telle détente provoquant alors un abaissement de la température de ce flux gazeux.

Ces pâles ou ailettes utilisent l'énergie cinétique du fluide gazeux M3 haute pression pour mettre en rotation le porte-échantillon 12. L'énergie du fluide gazeux haute pression qui traverse alors une turbine de détente est caractérisée par sa vitesse et par son enthalpie. En passant dans la turbine de détente, le fluide compressible subit une détente du type isentropique dont le rendement dépend de la géométrie constructive des pâles de la turbine de détente. Ainsi, l'énergie contenue dans ce fluide est traité par la turbine de détente pour refroidir davantage l'échantillon et/ou pour alléger la consommation énergétique du dispositif 7.

Le fluide du flux gazeux M3 haute pression qui transite dans la turbine de détente subit donc une évolution réelle plus ou moins éloignée de l'évolution idéale isentropique. Le rendement isentropique (adiabatique) de la turbine de détente est l'expression de l'écart entre les deux évolutions ou encore du rapport du travail récupéré lors de l'évolution réelle sur le travail récupéré lors d'une évolution isentropique.

En négligeant les variations d'énergie cinétique et d'énergie potentielle entre l'entrée et la sortie de la turbine de détente, elle-même supposée adiabatique, le rendement isentropique est égal au rapport des enthalpies correspondantes. La variation d'enthalpie constatée équivaut à une variation de température du gaz. Plus le rendement isentropique est élevé, plus la baisse de température est conséquente.

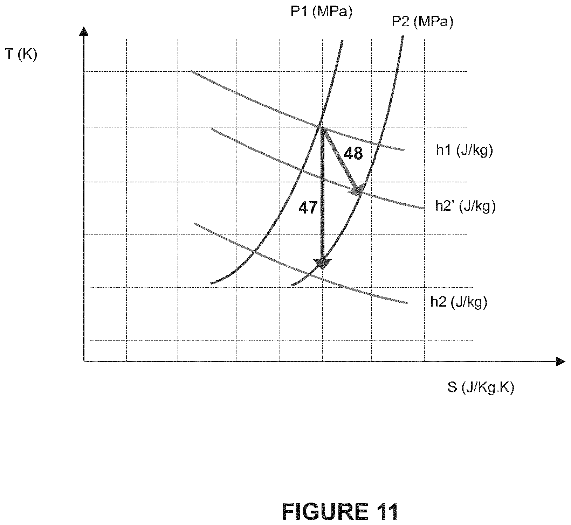

Le diagramme de la figure 11 illustre cette notion de rendement encore dénommé facteur de qualité. Lors d'une détente en passant d'une haute pression P1 à une basse pression P2, la flèche 47 indique une évolution idéale isentropique avec une variation d'enthalpie (h1 à h2) et une baisse importante de température, alors que la flèche 48 montre ce que pourrait être une évolution réelle avec une variation d'enthalpie( h1 à h2') moins importante et par conséquent une baisse de température moins sensible.

La sonde 9 d'analyse par RMN est reliée au cryostat 8 par une ligne cryogénique 16 par laquelle passe différents éléments de canalisation de flux gazeux M1, M2, M3, M4, M5, M6, M7 de fluide gazeux M0. Ces éléments de canalisation sont par exemple à des lignes d'alimentation de fluide relatives à ces flux gazeux M1, M2, M3, M4, M5, M6, M7. Ces éléments de canalisation sont réalisés en un matériau métallique adapté à la cryogénie comme par exemple un matériau en nuance d'acier inoxydable austénitique dite à bas carbone, ou encore en cuivre.

On notera que les dispositifs 7 d'analyse par RMN ne comportent pas de ligne cryogénique 16 lorsque la sonde 9 est comprise dans le cryostat 8, comme l'illustre le mode de réalisation du dispositif 7 de la figure 6.

Dans ce dispositif 7 d'analyse RMN illustré aux figures 1 à 8, un élément de canalisation 27, relié à une extrémité au module de compression 10, se divise à son autre extrémité en trois éléments de canalisation 20, 21, 22. Ainsi que nous le verrons par la suite dans certains exemples tels que celui illustré en figure 2B, le dispositif 7 ne comprend pas de canalisation 27 car le module de compression correspond à trois compresseurs connectés respectivement aux premier, deuxième et troisième canalisations 22, 21, 20.

Les autres éléments de canalisation compris dans ce dispositif 7 d'analyse par RMN sont les suivants :
- un premier élément de canalisation 22 du flux gazeux M3 de fluide vers la turbine 14 ;
- un deuxième élément de canalisation 21 du flux gazeux M2 de fluide vers le palier 13 ;
- un troisième élément de canalisation 20 du flux gazeux M1 de fluide vers le porte-échantillon 12, et
- un quatrième élément de canalisation 23 du flux gazeux M6 de fluide en aval des rotor 31 et stator 30 du porte-échantillon 12, vers le module de compression 10, en traversant des composants du cryostat 8.

Dans les exemples de dispositifs 7 d'analyse par RMN illustrés aux figures 3, 4 et 5, lorsque ses composants sont configurés pour réaliser un cycle thermodynamique de Brayton :
- le premier élément de canalisation 22 du flux gazeux M3 véhicule ce flux de fluide vers une turbine 14 ;
- le quatrième élément de canalisation peut être remplacé par un élément de canalisation 24 du flux gazeux M4 de fluide en aval du rotor 31 du porte-échantillon 12, vers le module de compression 10, en traversant des composants du cryostat 8, et
- un cinquième élément de canalisation 25 est agencé dans ce dispositif 7, pour véhiculer le flux gazeux M5 de fluide récupéré en aval du stator 30 du porte-échantillon 12, vers le quatrième élément de canalisation 24. Il est apte à conduire le flux gazeux M5 dans le circuit de ce dispositif 7 au niveau du quatrième élément de canalisation 24 entre le cryoréfrigérateur 11 et le deuxième échangeur 19, c'est-à-dire en aval du deuxième échangeur 19 et en amont du cryoréfrigérateur 11.

Dans les modes de réalisation illustrés aux figures 6 à 8, dans lesquels des vannes et/ou des éléments de redirection sont agencés sur certains de ces éléments de canalisation, le dispositif 7 comprend d'autres éléments de canalisation :
- un sixième élément de canalisation 26 du flux gazeux M9 ;
- un septième élément de canalisation 29 qui est apte à établir une liaison entre les éléments de canalisation 20, 21, 22 et le quatrième élément de canalisation 23, et
- un huitième élément de canalisation 28 du flux gazeux M8 qui est apte à conduire ce flux gazeux M8 dans le circuit de ce dispositif 7 au niveau du quatrième élément de canalisation 23 entre le premier échangeur 18 de chaleur et cryoréfrigérateur 11, c'est-à-dire en aval du cryoréfrigérateur 11 et en amont du premier échangeur 18.

Ces éléments de canalisation forment le circuit de ce dispositif 7 d'analyse par RMN. Ce circuit se rapporte notamment, en fonction du mode de réalisation, aux éléments de canalisation 20, 21, 22, 23, 27, pour le dispositif 7 représenté aux figures 1, 2A et 5 à 8 ou aux éléments de canalisation 20, 21, 22, 24, 25, 27, pour les dispositifs 7 illustrés aux figures 3 et 4, ou encore aux éléments de canalisation 20, 21, 22, 23, pour le dispositif 7 représenté à la figure 2B.

On notera que les éléments de canalisation 27, 20, 21, 22 situé en aval du module de compression 10 et en amont du porte-échantillon 12 se rapportent à la partie haute pression du circuit, alors que les éléments de canalisation 24, 25 ou l'élément 23 situés en aval du porte-échantillon 12 et en amont du module de compression 10 correspondent à la partie basse pression du circuit.

Dans ces réalisations, le quatrième élément de canalisation 23 pour le dispositif 7 représenté aux figures 1, 2A, 2B et 5 à 8 (ou 24 pour les dispositifs 7 illustrés aux figures 3 et 4) traverse le cryoréfrigérateur 11 ainsi que le premier échangeur 18 à l'entrée e et la sortie a. En complément, on remarquera que les premier, deuxième et troisième éléments de canalisation 20, 21, 22 traversent respectivement le premier échangeur 18 aux entrées b, c, d et sorties f, g, h.

On notera que dans les exemples de dispositifs 7 d'analyse par RMN illustrés aux figures 3, 4 et 5, lorsque ses composants sont configurés pour réaliser un cycle thermodynamique de Brayton, les premier, deuxième éléments de canalisation 21,22 traversent respectivement le premier échangeur 18 aux entrées b, c et sorties f, g, et le deuxième échangeur 19 aux entrées v, w et sorties y, z. Le troisième élément de canalisation 23 traversant le premier échangeur 18 à l'entrée d et la sortie f. De plus dans ces exemples lorsque le flux gazeux M6 basse pression est formé par le flux gazeux M4 basse pression et le flux gazeux M5 basse pression, l'élément de canalisation 23 traverse le cryoréfrigérateur 11 ainsi que le premier échangeur 18 à l'entrée e et la sortie a, et notamment le deuxième échangeur 19 à l'entrée x et la sortie u.

Les figures 1 à 3 représentent des exemples de dispositif 7 d'analyse par RMN dans lesquelles ledit dispositif 7 comporte un cryostat 8 relié par une ligne cryogénique 16 à une sonde 9 d'analyse par RMN. Le cryostat 8 comporte un module de compression 10 froid et dans certains modes de réalisation un cryoréfrigérateur 11 et/ou au moins un échangeur 19, 18.

Ainsi que nous l'avons vu précédemment, le fluide gazeux M0 va subir une compression de la part du module de compression 10. A la sortie de ce module de compression 10 au point 1 des figures 1, 2A, 2B et 3, ce fluide gazeux M0 est alors un fluide gazeux M0 haute pression (HP). Lors de cette compression la température de ce fluide gazeux M0 haute pression a augmentée puisque le milieu extérieur a fourni du travail au système ce qui augmente son énergie interne et donc son agitation thermique.

Dans un premier exemple de dispositif 7 d'analyse par RMN illustré à la figure 1, ce dispositif 7 comporte un cryostat 8 relié à un une sonde 9 par une liaison cryogénique 16. Le cryostat 8 comporte un module de compression 10 froid et un cryoréfrigérateur 11. La sonde 9 comporte un porte-échantillon 12. Le cryoréfrigérateur 11 est agencé entre le module de compression 10 froid et le porte-échantillon 12, en aval du porte-échantillon 12 et en amont du module de compression 10 froid.

Dans cet exemple, ce fluide gazeux M0 haute pression à une température au point 1 qui est comprise entre 10 et 14 K. Ce fluide gazeux M0 haute pression est divisé en trois flux M1, M2, M3 de fluide gazeux M0 haute pression après avoir traversé le module de compression 10. Chacun des flux gazeux M1, M2, M3 haute pression est respectivement conduit, jusqu'au niveau de l'enceinte 35 proche de la sortie du cryostat 8 du point 1 au 3', par les éléments de canalisation 20, 21, 22. Au point 3', la température de ces flux gazeux M1, M2, M3 haute pression est encore comprise entre 10 et 14 K.

A la sortie du cryostat 8, ces flux gazeux M1, M2, M3 haute pression sont conduits jusqu'à la sonde 9 d'analyse par RMN, et plus particulièrement vers le porte-échantillon 12.

En effet, chacun de ces flux gazeux M1, M2, M3 de fluide haute pression est destiné respectivement au refroidissement de l'échantillon, à la sustentation ou au guidage de l'échantillon et à la mise en rotation de l'échantillon. Plus précisément, le premier flux gazeux M1 de fluide a pour fonction de porter le porte-échantillon 12 et/ou l'échantillon à une certaine température. Le second flux M2 a pour fonction de créer un palier 13 aérostatique ou aérodynamique de sustentation ou au guidage du rotor 31 dans le stator 30, et le troisième flux M3 de mettre en rotation ce porte-échantillon 12, en agissant sur les pâles ou ailettes de la turbine d'entraînement d'un rotor 31 qui comprend le porte-échantillon 12.

Dans la sonde 9, des flux gazeux M4 et M5 basse pression sont récupérés au niveau du rotor 31 et stator 30 du porte-échantillon 12 de sorte à ne former qu'un flux gazeux M6 basse pression. Ce flux gazeux M6 basse pression est conduit vers le cryostat 8 par le quatrième élément de canalisation 23. Le flux gazeux M5 récupéré en sortie du stator 30 du porte-échantillon correspond aux flux résultants des flux gazeux M1, M2 haute pression ayant respectivement porté l'échantillon et/ou le porte échantillon à une certaine température et créé un palier 13 aérostatique ou aérodynamique de sustentation ou de guidage du rotor 31 dans le stator 30.

Ce flux gazeux M6 basse pression en pénétrant dans le cryostat 8 à une température comprise, au point 3, entre 13 et 17K. Ce flux gazeux M7 basse pression traverse ensuite le cryoréfrigérateur 11 avant d'atteindre le module de compression 10.

A la sortie de ce cryoréfrigérateur 11, au point 4, le flux gazeux M7 basse pression, qui se rapporte au flux gazeux résultant de la traversée par le flux gazeux M6 de ce cryoréfrigérateur 11, a atteint une température très basse comprise entre 8 et 12K. La température de ce flux gazeux M7 basse pression est inférieure à celle des flux gazeux M1, M2, M3 haute pression.

Le flux gazeux M7 basse pression traverse ensuite le module de compression 10 duquel il ressort sous la forme d'un fluide gazeux M0 haute pression.

Dans un deuxième exemple de dispositif 7 d'analyse par RMN illustré à la figure 2A, ce dispositif 7 est sensiblement similaire à celui du premier exemple. En effet, ce dispositif 7 comporte un composant supplémentaire par rapport à ce premier exemple qui est agencé dans l'enceinte 35 cryostat 8. Ce composant correspond à un échangeur 18 de chaleur positionné entre le cryoréfrigérateur 11 et le module de compression 10, ici un compresseur froid, de manière à être situé en aval du cryoréfrigérateur 11 et en amont du module de compression 10 froid.

Dans cet exemple, le fluide gazeux M0 haute pression à une température au point 1 qui est comprise entre 28 et 32K. Ce fluide gazeux M0 haute pression est divisé en trois flux M1, M2, M3 de fluide gazeux M0 haute pression après avoir traversé le module de compression 10 froid. Chacun de ces flux gazeux M1, M2, M3 haute pression pénètre dans l'échangeur 18 de chaleur respectivement aux entrées b, c, d.

Cet échangeur 18 de chaleur est par exemple un échangeur de type fluide/fluide tubulaire à contre-courant décrit aux figures 13 et 14.

Cet échangeur 18 comprend trois tubes B haute pression pour la circulation dans une première direction des trois flux gazeux M1, M2, M3 de fluide haute pression. Ces trois tubes B sont positionnés à l'intérieur d'un grand tube C basse pression dans lequel circule le flux gazeux M7 basse pression de fluide basse pression, dans une seconde direction inverse. Ce flux gazeux M7 basse pression, circulant en direction inverse des flux gazeux M1, M2, M3 de fluide haute pression, correspond au flux gazeux résultant de la traversée par le flux gazeux M6 basse pression du cryogénérateur 11. En traversant le cryoréfrigérateur 11, le flux M7 atteint des températures très basses.

A la sortie du cryogénérateur 11 au point 4 et avant de pénétrer dans l'échangeur 18 par l'entrée e, la température du le flux gazeux M7 basse pression est comprise entre 13 et 17K. De fait, le flux gazeux M7 basse pression a alors une température bien inférieure à celles des flux gazeux M1, M2, M3 pénétrant par les entrées b, c, d de l'échangeur 18.

Dans cet échangeur 18, du point 1 au point 2, un transfert thermique 33 est réalisé entre les deux fluides, celui du flux gazeux M7 basse pression et des flux gazeux M1, M2, M3 haute pression. Ce transfert thermique 33 induit un refroidissement des flux gazeux M1, M2, M3 haute pression. La répartition symétrique des trois tubes haute pression au sein du flux gazeux M7 garantit la même température de sortie pour les trois flux gazeux M1, M2, M3. Ainsi cette température abaissé des flux gazeux M1, M2, M3 haute pression est comprise en sortie de cet échangeur 18 de chaleur, au point 2, entre 16 et 20 K.

S'agissant du flux gazeux M7 basse pression, sa température après la traversée de l'échangeur 18 a augmentée pour être comprise au point 5 entre 25 et 29K. En effet, comme nous l'avons précédemment vu, lors du transfert thermique 33 entre ce flux gazeux M7 basse pression et les flux gazeux M1, M2, M3 haute pression, ces derniers ont cédés de la chaleur.

Ainsi, les trois flux gazeux M1, M2, M3 haute pression refroidis quittent alors l'échangeur 18 par les sorties f, g, h pour être conduits par les éléments de canalisation 20, 21, 22, en traversant le cryostat 8, vers la sonde 9 d'analyse par RMN, pour atteindre le porte-échantillon 12.

Ensuite, ce flux gazeux M7 basse pression traverse le module de compression 10 duquel il résulte en sortie, un fluide gazeux M0 haute pression.

Dans la variante de ce deuxième exemple du dispositif 7 d'analyse par RMN illustrée à la figure 2B, ce dispositif 7 est sensiblement similaire à celui de ce deuxième exemple. En effet, dans ce dispositif 7, le module de compression 10 correspond à trois compresseurs froids aptes à fournir chacun un des flux gazeux M1, M2, M3 à l'échangeur 18 de chaleur. Dans cette variante, le fluide gazeux parcours le circuit de ce dispositif 7 d'analyse par RMN selon le même processus mis en oeuvre pour le deuxième exemple.

Dans un troisième exemple de dispositif 7 d'analyse par RMN, illustré à la figure 3, ce dispositif 7 diffère de celui du deuxième exemple en ce qu'il comporte le deuxième échangeur 19 de chaleur. Ce deuxième échangeur 19 est agencé dans le cryostat 8, entre la sonde 9 et le cryoréfrigérateur 11. Dans cet exemple, les composants de ce dispositif 7 sont configurés pour réaliser un cycle thermodynamique de Brayton.

Dans cet exemple, le fluide gazeux M0 haute pression à une température au point 1, à la sortie du module de compression 10, qui est comprise entre 28 et 32K. Ce fluide gazeux M0 haute pression est divisé en trois flux M1, M2, M3 de fluide gazeux M0 haute pression après avoir traversé le module de compression 10.

Du point 2 au point 3 des figures 3,9 et 10, chacun de ces flux gazeux M1, M2, M3 haute pression traverse l'échangeur de chaleur 18 selon le même processus mis en oeuvre dans le deuxième exemple de dispositif 7 représenté en figure 2A.

Ainsi ces flux gazeux M1, M2, M3 haute pression atteignent aux sorties f, g, h de cet échangeur 18, c'est-à-dire au point 3, des températures comprises entre 23 et 27K. En effet, lors du transfert thermique 33 réalisé entre les points 2 et 3, dans cet échangeur 18, entre les deux fluides, celui du flux gazeux M7 basse pression et des flux gazeux M1, M2, M3 haute pression, la température de ces derniers s'est abaissée. Alors que lors de ce transfert thermique 33 réalisé entre les points 5 et 6, celle du flux gazeux M7 a augmenté pour être comprise entre 25 et 29K, en sortie a de cet échangeur 18, au point 6.

En sortant, du deuxième échangeur 18, les flux gazeux M1, M2 haute pression sont conduits vers le deuxième échangeur 19 par les deuxième et troisième éléments de canalisation 20,21, tandis que le flux gazeux M3 haute pression est conduit vers la turbine 14, par le premier élément de canalisation 22 et plus particulièrement vers les pâles ou ailettes d'une ou des turbines de détente du porte-échantillon 12.

Ce deuxième échangeur 19 est également du type fluide/fluide tubulaire à contre-courant, comme le premier échangeur 18. Dans ce deuxième échangeur 19, du point 3 au point 4', un transfert thermique 34 est réalisé entre les deux fluides, celui du flux gazeux M4 basse pression et des flux gazeux M1, M2 haute pression. Ce transfert thermique 34 induit un refroidissement des flux gazeux M1, M2 haute pression, dont la température abaissée, au point 4' en sortie y, z de ce deuxième échangeur 19, est comprise entre 13 et 17 K. Ces deux flux gazeux M1, M2 haute pression refroidis quittent ensuite le cryostat 8 pour être conduits par les éléments de canalisation 20, 21, vers la sonde 9 d'analyse par RMN pour atteindre le porte-échantillon 12.

S'agissant du flux gazeux M4 basse pression, lors de transfert thermique 34 du point 4 au point 5 des figures 3, 9 et 10, sa température a augmentée après la traversée du deuxième échangeur 19. Cette température est comprise au point 5 entre 20 et 24 K. En effet, lors du transfert thermique 34 entre ce flux gazeux M4 basse pression et les flux gazeux M1, M2 haute pression, ces derniers ont cédés de la chaleur. On notera que la température au point 4 correspond à celle du flux gazeux M4 résultant de la turbine 14.

Dans cet exemple, le flux gazeux M4 basse pression résulte du passage dans la turbine 14, du flux gazeux M3 qui est par la suite conduit vers l'entrée x du deuxième échangeur 19 par le quatrième élément de canalisation 24, au point 4.

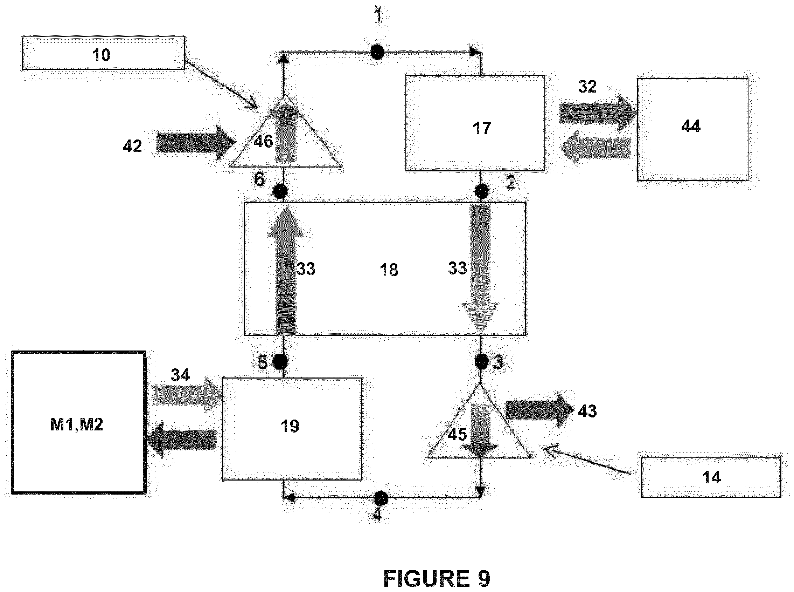

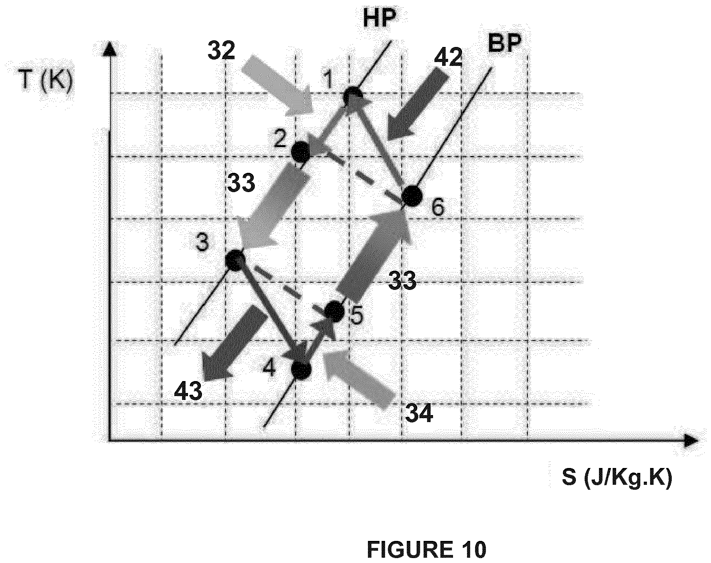

Le flux gazeux M4 basse pression a alors une température plus basse que le flux gazeux M3 haute pression, qui est obtenu par la détente du fluide de flux gazeux M3 haute pression dans la turbine de détente. Cette détente du fluide du flux gazeux M3 est illustrée aux figures 9 et 10 du point 3 au point 4. Lors de cette détente, la température du flux gazeux M3 a diminuée car le système a fourni du travail au milieu extérieur ainsi que l'illustre la flèche 43 aux figures 9 et 10.

Le flux gazeux M5 basse pression est quant à lui récupéré en sortie du stator 30 du porte-échantillon 12, et correspond aux flux résultants des flux gazeux M1, M2 ayant respectivement porté l'échantillon à une certaine température et créé un palier 13 aérostatique ou aérodynamique de sustentation ou guidage du rotor 31 dans le stator 30. Ce flux gazeux M5 basse pression est injecté, par le cinquième élément de canalisation 25, entre le deuxième échangeur 19 et le cryoréfrigérateur 11 compris dans le cryostat 8, c'est-à-dire au point 5. Ce flux gazeux M5 basse pression combiné avec le flux résultant du passage du flux gazeux M4 basse pression dans le deuxième échangeur 19 constitue alors le flux gazeux M6 basse pression.

Ce flux gazeux M6 basse pression, traverse le cryoréfrigérateur 11. Le flux résultant de cette traversée correspond au flux gazeux M7 qui a une température plus basse que celle du flux gazeux M6. Ce flux gazeux M7 basse pression pénètre dans le premier échangeur 18, dans lequel les flux gazeux M1, M2, M3 haute pression cèdent de la chaleur audit flux gazeux M7 basse pression, selon le processus expliqué précédemment.

Par la suite, le flux gazeux M7 basse pression, du point 6 au point 1, traverse le module de compression 10 froid duquel il résulte en sortie, un fluide gazeux M0 haute pression.

Dans un quatrième exemple de dispositif 7 d'analyse RMN illustré à la figure 4, les composants de ce dernier sont, de manière sensiblement similaire au troisième exemple, configurés pour réaliser un cycle thermodynamique de Brayton. Le dispositif 7 diffère de celui du troisième exemple en ce qu'il comporte un module de compression 10 chaud, et non un module de compression 10 froid. Ce module de compression 10 chaud étant agencé à l'extérieur de l'enceinte 35 du cryostat 8 et relié au troisième échangeur 17 de chaleur, situé également à l'extérieur de ce cryostat 8.

Dans cet exemple, le fluide gazeux M0 va subir une compression de la part du module de compression 10, du point 6 au point 1 des figures 4, 9 et 10. A la sortie de ce module de compression 10 ce fluide gazeux M0 est alors un fluide gazeux M0 haute pression (HP). Lors de cette compression la température de ce fluide gazeux M0 haute pression a augmentée puisque le milieu extérieur a fourni du travail au système ce qui a pour conséquence d'augmenter son énergie interne et donc son agitation thermique, ainsi que l'illustre la flèche 42 aux figures 9 et 10. Dès lors, à la sortie du module de compression 10 cette température est comprise entre 330 et 370 K.

Ce fluide gazeux M0 haute pression traverse ensuite le troisième échangeur 17 de chaleur situé à l'extérieur du cryostat 8, du point 1 au point 2 des figures 4, 9 et 10. Dans ce troisième échangeur 17 de chaleur, un transfert thermique est réalisé entre ce fluide gazeux M0 haute pression et l'environnement 44 immédiat dans lequel est localisé le dispositif 7 d'analyse par RMN. Sa température est alors abaissée sensiblement au niveau de la température ambiante relative à cet environnement, ou au voisinage d'une telle température. Ce fluide gazeux M0 haute pression a donc cédé de la chaleur lors d'un transfert thermique 32 dans ce troisième échangeur 17 avec l'environnement 44. A la sortie de ce troisième échangeur 17, la température abaissée du fluide gazeux M0 haute pression est comprise entre 280 et 320 K.

A la sortie de ce troisième échangeur 17 le fluide gazeux M0 haute pression est divisé en trois flux gazeux M1, M2, M3 de fluide haute pression. Chacun de ces flux gazeux M1, M2, M3 haute pression traverse ensuite le cryostat 8 et la sonde 9 selon le même processus mis en oeuvre dans le troisième exemple de dispositif 7 d'analyse par RMN.

Dans ce quatrième exemple, les températures aux différents stades de progression du fluide gazeux M0 dans le dispositif 7 sont les suivantes :
- aux sorties f, g, h du premier échangeur 18 de chaleur, au point 3, la température abaissé des flux gazeux M1, M2, M3 haute pression est comprise entre 23 et 27 K ;
- à la sortie a du premier échangeur 18, au point 6, le flux gazeux M7 basse pression a une température qui a augmentée pour être comprise entre 277 et 317 K ;
- à la sortie u du deuxième échangeur 19, le flux gazeux M6 basse pression à une température comprise entre 20 et 24K ;
- aux sorties y, z du deuxième échangeur 19 de chaleur la température abaissée des flux gazeux M1, M2 haute pression est comprise entre 13 et 17K, et
- à l'entrée x du deuxième échangeur 19, le flux gazeux M4 basse pression à une température comprise entre 10 et 14K.

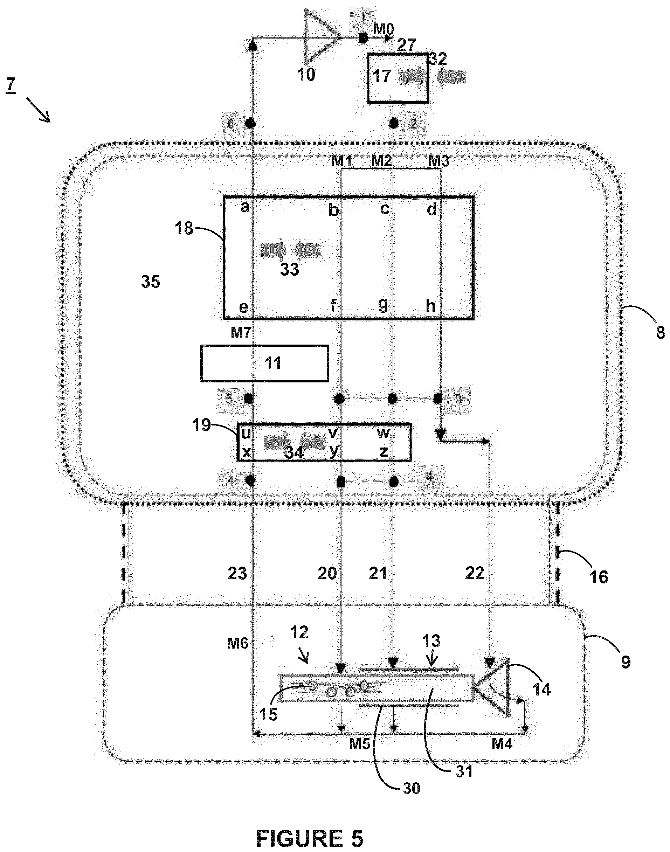

Dans un cinquième exemple de dispositif 7 d'analyse par RMN illustré à la figure 5, ce dispositif 7 est sensiblement similaire à celui du quatrième exemple. Cependant, il diffère de ce quatrième exemple, en ce qu'il comporte un quatrième élément de canalisation 23 du flux gazeux M6 de fluide récupéré en aval des rotor 31 et stator 30 du porte-échantillon 12 susceptible de véhiculer le flux gazeux M6 vers le deuxième échangeur 19. En effet, dans le quatrième exemple, le quatrième élément de canalisation 24 conduisait un flux gazeux M4 récupéré en aval du rotor 31 du porte-échantillon 12, vers le deuxième échangeur 19.

De plus dans ce exemple, ce flux gazeux M6 basse pression est formé par le flux gazeux M4 basse pression et le flux gazeux M5 basse pression, à la différence du flux gazeux M6 définie dans le quatrième exemple qui est formé par le flux gazeux M5 et le flux gazeux résultant du passage du flux gazeux M4 dans le deuxième échangeur 19.

Dans ce cinquième exemple, le fluide gazeux M0 parcours le circuit de ce dispositif 7 d'analyse par RMN selon le même processus mis en oeuvre pour le quatrième exemple.

On notera que dans ce dispositif 7, les températures aux différents stades de progression du fluide gazeux M0 sont sensiblement similaires à celles du quatrième exemple, à l'exception de celle du flux gazeux M6, à l'entrée x du deuxième échangeur 19 de chaleur, au point 5, qui est comprise entre 11 et 15 K.

On remarque, que cette température en entrée x du deuxième échangeur 19 de chaleur est de manière générale supérieure à celle obtenue à cette même entrée x du deuxième échangeur 19 dans le quatrième exemple. Elle reste cependant suffisante pour permettre un échange thermique à contre-courant dans le deuxième échangeur 19.

Dans d'autres modes de réalisation représentés aux figures 6 à 8, le dispositif 7 d'analyse par RMN comporte des composants tels que des vannes et/ou des éléments de redirection qui sont agencés sur certains éléments de canalisation.

Dans ces modes de réalisation, le dispositif 7 d'analyse par RMN est apte à fonctionner selon différentes configurations définies par l'activation des vannes et/ou des éléments de redirection. Ainsi, les vannes peuvent donc alterner entre un mode ouvert et un mode fermé et les éléments de redirection passer d'un état activé à un état désactivé et inversement.

Dans un premier mode de réalisation du dispositif 7 d'analyse par RMN illustré à la figure 6, un module de compression 10 chaud est agencé à l'extérieur de l'enceinte 35 du cryostat 8. Dans ce mode de réalisation, le troisième échangeur 17 de chaleur, situé également à l'extérieur de ce cryostat 8, est relié à la fois à ce module de compression 10 chaud et à une unité de stockage 41 de fluide haute pression qui est également relié au cryostat 8.

Ce cryostat 8 en plus de comporter, comme dans le deuxième exemple, le premier échangeur 18 de chaleur et un cryoréfrigérateur 11, comprend la sonde 9 d'analyse par RMN dans son enceinte 35.

Ce dispositif 7 comprend également une source de fluide cryogénique externe 40 qui est reliée au circuit entre le premier échangeur 18 et le cryoréfrigérateur 11.

Dans ce premier mode de réalisation, le dispositif 7 d'analyse par RMN comporte six vannes A1, A2, A3, A4, A5, A6 :
- l'élément de bouclage A1 est monté sur le quatrième élément de canalisation 23 en aval du premier échangeur 18 à l'extérieur du cryostat 8 et en amont de l'élément de bouclage A5. Il permet de contrôler l'évacuation du flux gazeux M7 vers l'environnement extérieur en aval du premier échangeur 18 ;
- l'élément de bouclage A2 est monté sur le huitième élément de canalisation 28. Il permet de contrôler l'introduction du flux gazeux M8 de fluide cryogénique au niveau du quatrième élément de canalisation 23 en amont du premier échangeur 18 et en aval du cryoréfrigérateur 11 ;
- l'élément de bouclage A3 est monté sur le septième élément de canalisation 26. Il permet de contrôler l'accès du flux gazeux M6 à ce septième élément de canalisation 26 ;
- l'élément de bouclage A4 est monté sur l'élément de canalisation 27 en aval du troisième échangeur 17 de chaleur et en amont de l'unité de stockage 41 de fluide haute pression. Il permet de contrôler l'accès du fluide gazeux M0 haute pression à cette unité de stockage 41 ;
- l'élément de bouclage A5 est monté sur le quatrième élément de canalisation 23 en aval de l'élément de bouclage A1 et en amont du module de compression 10 chaud. Il permet de contrôler l'accès du flux gazeux basse pression M7 au module de compression 10, et
- l'élément de bouclage A6 est monté sur le quatrième élément de canalisation 23 en aval du porte-échantillon 12 et en amont du cryoréfrigérateur 11.

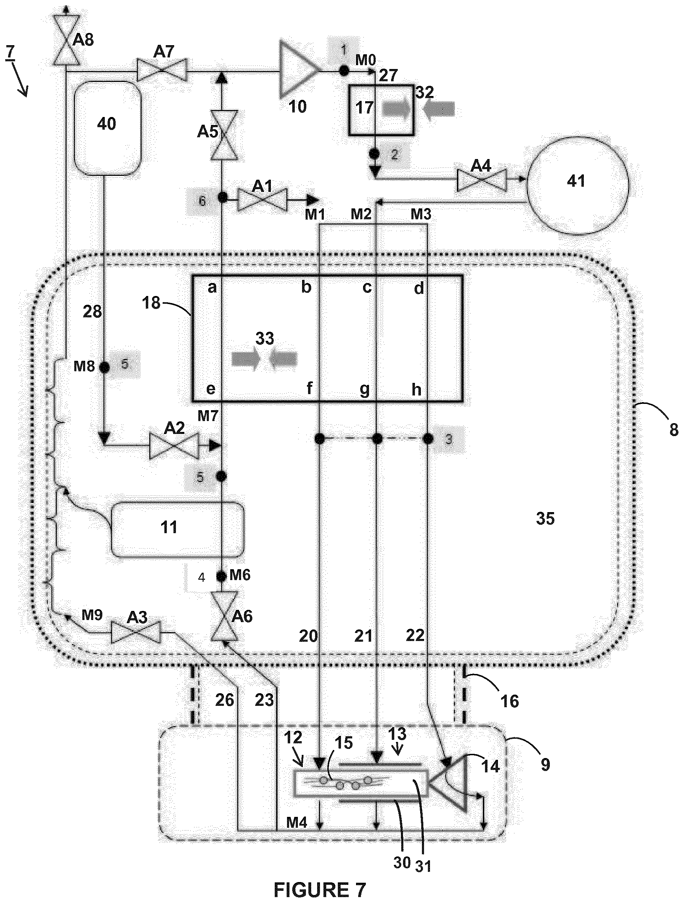

Dans un deuxième mode de réalisation du dispositif 7 illustré à la figure 7, à la différence du premier mode de réalisation, la sonde 9 d'analyse par RMN est comprise à l'extérieur du cryostat 8 et le septième élément de canalisation 26 est relié au quatrième élément de canalisation 23 à l'extérieur du cryostat 8.

Dans ce mode de réalisation, le dispositif 7 d'analyse par RMN comporte deux vannes A7, A8 supplémentaires par rapport au dispositif 7 du premier mode de réalisation. L'élément de bouclage A7 est monté sur le septième élément de canalisation 26 en aval de l'élément de bouclage A3 et en amont du module de compression 10 chaud. L'élément de bouclage A7 permet de contrôler l'accès du flux gazeux M9 au module de compression 10 chaud.

S'agissant de l'élément de bouclage A8, ce dernier est également monté sur le septième élément de canalisation 26 en aval de l'élément de bouclage A3 et en amont de l'élément de bouclage A7. Cet élément de bouclage A8 permet de contrôler l'évacuation du flux gazeux M9 vers l'environnement 44 extérieur.

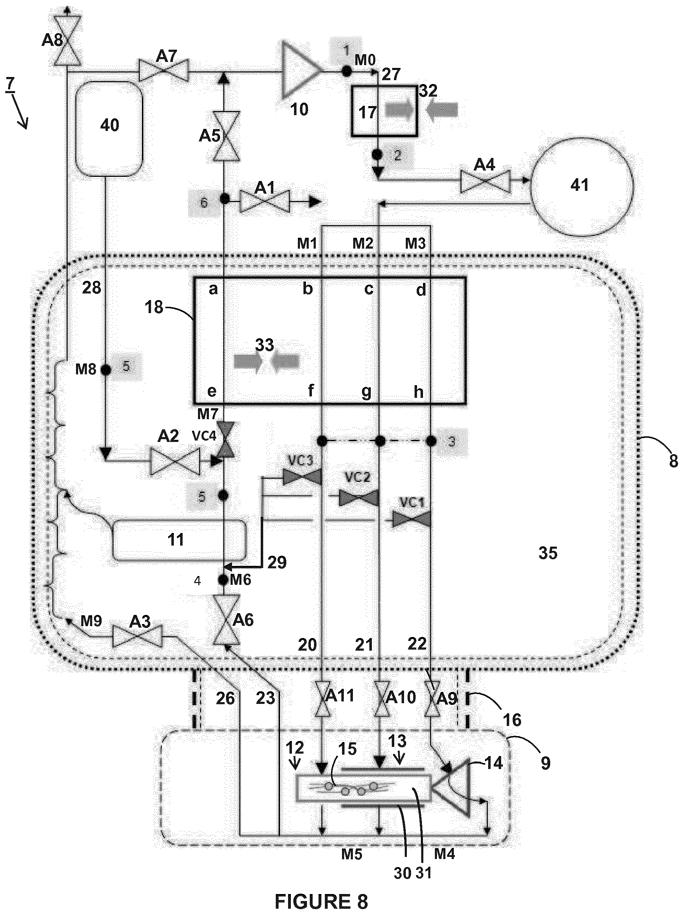

Dans un troisième mode de réalisation du dispositif 7 d'analyse par RMN illustré à la figure 8, le dispositif 7 est similaire à celui du deuxième mode de réalisation. Cependant, dans le présent mode de réalisation, le dispositif 7 comprend des éléments de redirection VC1, VC2, VC3, VC4.

Ces éléments de redirection VC1, VC2, VC3, VC4 peuvent passer d'un état activé à un état désactivé et inversement.

Les éléments de redirection VC1, VC2, VC3 sont respectivement montés sur les éléments de canalisation 22, 21, 20. Ces élément de redirection VC1, VC2, VC3 sont agencés en aval du premier échangeur 18 et respectivement en amont des vannes A9, A10, A11.

Ils permettent de contrôler la redirection des flux gazeux M3, M2, M1 vers la sonde 9 ou vers le septième élément de canalisation 29.

L'élément de redirection VC4 est monté sur le quatrième élément de canalisation 23 et est agencé en aval du cryoréfrigérateur 11 et en amont du premier échangeur 18. Cet élément de redirection VC4 permet de contrôler l'accès du flux gazeux provenant du septième élément de canalisation 29, au niveau du quatrième élément de canalisation 23 entre le cryoréfrigérateur 11 et le premier échangeur 18.

Dans ce mode de réalisation, le dispositif 7 d'analyse par RMN comporte trois vannes A9, A10, A11 supplémentaires par rapport au dispositif 7 du deuxième mode de réalisation. L'élément de bouclage A11 est monté sur le troisième élément de canalisation 20 en aval du premier échangeur 18 et en amont de la sonde 9 d'analyse par RMN et permet de contrôler l'accès du flux gazeux M1 à ladite sonde 9.

Concernant l'élément de bouclage A10, il est monté sur le deuxième élément de canalisation 21 en aval du premier échangeur 18 et en amont de la sonde 9 d'analyse par RMN et permet de contrôler l'accès du flux gazeux M2 à ladite sonde 9.

S'agissant de l'élément de bouclage A9, il est monté sur le premier élément de canalisation 22 en aval du premier échangeur 18 et en amont de la sonde 9 d'analyse par RMN et permet de contrôler l'accès du flux gazeux M3 à ladite sonde 9.

Ainsi que nous l'avons vu, dans ces modes de réalisation représentés aux figures 6 à 8, le dispositif 7 d'analyse par RMN est apte à fonctionner selon différentes configurations définies par l'activation des vannes et/ou des éléments de redirection. En effet, les vannes peuvent alterner entre un mode ouvert et un mode fermé et les éléments de redirection passer d'un état activé à un état désactivé et inversement. Ces configurations correspondent à différents modes de fonctionnement de ces modes de réalisation du dispositif 7.

Dans le premier mode de réalisation illustré à la figure 6, le dispositif 7 d'analyse par RMN comporte six vannes à partir desquels, et manière non exhaustive, trois modes de fonctionnement, selon la configuration donnée à ces vannes A1, A2, A3, A4, A5, A6, peuvent être définis.

Dans le deuxième mode de réalisation du dispositif 7 représenté à la figure 7, ce dispositif 7 comporte huit vannes A1, A2, A3, A4, A5, A6, A7, A8, tandis que dans le troisième mode de réalisation il comprend onze vannes A1, A2, A3, A4, A5, A6, A7, A8, A11, A10, A11. De plus, comme nous l'avons vu précédemment, dans ce troisième mode de réalisation, le dispositif 7 comporte quatre éléments de redirection VC1 à VC4.

Dans les deuxième et troisième modes de réalisation, les différentes configurations, définissant le mode d'activation de ces vannes et des éléments de redirection, permettent de mettre en oeuvre un procédé de fonctionnement d'un dispositif d'analyse par RMN comprenant des étapes de mises en oeuvre d'au moins cinq modes de fonctionnement du dispositif 7 d'analyse par RMN. Le nombre de mode de fonctionnement décrit pour chacun des modes de réalisation du dispositif 7, n'est bien entendu pas exhaustif.

On notera de manière non limitative, que pour les premier au quatrième modes de fonctionnement mis en oeuvre notamment au niveau du troisième mode de réalisation, les vannes A9, A10, A11 sont en mode ouvert et les éléments de redirection VC1 à VC4 ne sont pas activées.

Dans le premier mode de fonctionnement, les vannes A1, A2, A3, A7 sont configurées en mode fermé et les autres vannes sont en mode ouvert. Dès lors une telle configuration des vannes implique alors que :
- le flux gazeux M8 de fluide cryogénique émanant de la source de fluide cryogénique 40 ne peut pas pénétrer dans le circuit de ce dispositif 7 d'analyse par RMN par l'élément de bouclage A2 ;
- le flux gazeux M7 provenant du premier échangeur 18 ne peut pas être évacué du circuit vers l'environnement 44 extérieur par l'élément de bouclage A1, et
- le flux gazeux M6 basse pression résultant des flux gazeux M4, M5 basse pression ne peut pas accéder au sixième élément de canalisation 26 par l'élément de bouclage A3.

Ainsi, les vannes A1, A2 et A3 étant fermées, le dispositif 7 d'analyse RMN est dans une configuration dans laquelle le circuit correspond à une boucle unique fermée et pressurisée. La réfrigération et la motorisation du porte-échantillon 12 sont réalisées par cette boucle unique.

Dans ce mode de fonctionnement, le fluide gazeux M0 va subir une compression de la part du module de compression 10. A la sortie de ce module de compression 10, au point 1 des figures 6 à 8, ce fluide gazeux est alors un fluide gazeux haute pression. Lors de cette compression, la température de ce fluide gazeux M0 haute pression a augmentée du fait que le milieu extérieur a fourni du travail au système, ce qui a pour conséquence d'augmenter son énergie interne et donc son agitation thermique. Au point 1, cette température est comprise entre 330 et 370K. Ce module de compression 10 permet notamment de définir le débit du fluide gazeux dans ce circuit.

Ce fluide gazeux haute pression traverse ensuite le troisième échangeur 17 de chaleur du point 1 au point 2. Dans ce troisième échangeur 17 de chaleur, un transfert thermique 32 est réalisé entre ce fluide gazeux M0 haute pression et l'environnement 44 immédiat dans lequel est localisé le dispositif 7 d'analyse par RMN. Sa température est alors abaissée sensiblement au niveau de la température ambiante de cet environnement 44, ou au voisinage d'une telle température.

Ce fluide gazeux haute pression a donc cédé de la chaleur lors d'un transfert thermique 32 dans ce troisième échangeur 17 avec l'environnement 44 extérieur du dispositif 7.

A la sortie de ce troisième échangeur 17, point 2, la température abaissée du fluide gazeux M0 haute pression est comprise entre 280 et 320 K.

Le fluide gazeux M0 haute pression est alors par la suite conduit vers l'unité de stockage 41 de fluide gazeux M0 haute pression. Cette dernière est utilisée comme volume tampon de fluide gazeux pour réguler la pression du processus dans le circuit du dispositif 7 d'analyse par RMN.

A la sortie de l'unité de stockage 41, le fluide gazeux M0 haute pression est divisé en trois flux gazeux M1, M2, M3 de fluide haute pression. Chacun de ces flux gazeux M1, M2, M3 haute pression traverse ensuite le cryostat 8, notamment le premier échangeur 18, la sonde 9 et le cryoréfrigérateur 11, selon le même processus mis en oeuvre notamment dans le deuxième exemple de dispositif 7 d'analyse par RMN.

Dans le premier mode de réalisation du dispositif 7, les températures aux différents stades de progression du fluide gazeux M0 dans le circuit du dispositif 7 sont les suivantes :
- aux sorties f, g, h du premier échangeur 18 de chaleur la température abaissé des flux gazeux M1, M2, M3 haute pression est comprise entre 10 et 14K ;
- à la sortie a du premier échangeur 18, le flux gazeux M7 basse pression a une température qui a augmentée pour être comprise entre 277 et 317 K ;
- en aval du porte-échantillon et en amont du cryoréfrigérateur 11, la température du fluide gazeux basse pression M6 est comprise entre 13 et 17K, et
- à la sortie du cryoréfrigérateur 11, le flux gazeux M7 basse pression a une température abaissée comprise entre 7 et 11K.

Le flux gazeux M7 basse pression traverse ensuite le module de compression 10 chaud dans lequel il est compressé de sorte à se rapporter en sortie de ce module de compression 10, à un fluide gazeux M0 haute pression.

Dans un deuxième mode de fonctionnement, les vannes A2, A3, A4, A5, sont configurées en mode fermé et les autres vannes en mode ouvert.

Dès lors une telle configuration des vannes implique alors que :
- le flux gazeux M8 de fluide cryogénique émanant de la source de fluide cryogénique 40 ne peut pas pénétrer dans le circuit de ce dispositif 7 d'analyse par RMN par l'élément de bouclage A2 ;
- le module de compression 10 et le troisième échangeur 17 sont isolés du reste du circuit par la fermeture des vannes A5 et A4, et
- le flux gazeux M7 provenant du premier échangeur 18 est évacué du circuit vers l'environnement 44 extérieur par l'élément de bouclage A1.

Ainsi, les éléments de bouclage A5 et A4 étant fermées et l'élément de de bouclage A1 ouvert, le dispositif 7 d'analyse par RMN est dans une configuration dans laquelle le circuit correspond à une boucle unique ouverte. La réfrigération et la motorisation du porte-échantillon sont réalisées par cette boucle unique ouverte.

Dans ce mode de fonctionnement, l'unité de stockage 41 de fluide haute pression est utilisée comme réserve susceptible de diffuser dans le circuit du dispositif 7 le fluide gazeux qui y est stocké, en assurant le débit de ce fluide dans la boucle à la place du module de compression 10 chaud. Trois flux gazeux M1, M2, M3 haute pression provenant de cette unité de stockage 41 sont conduits vers le cryostat 8 afin de le traverser selon un processus de parcours du circuit du dispositif 7 d'analyse RMN sensiblement similaire à celui mis en oeuvre lors du premier mode de fonctionnement.

Dans le présent mode de fonctionnement, le cryoréfrigérateur 11 assure la descente en température des flux gazeux M1, M2, M3 à une température cryogénique.

A la sortie du cryostat 8, le fluide gazeux M7 est évacué par l'élément de bouclage A1 vers l'environnement 44 extérieur, puisque l'élément de bouclage A5 est en mode fermé. Ainsi, le fluide gazeux est utilisé à perte jusqu'à ce que l'unité de stockage 41 en soit complètement vidée.

Dans un troisième mode de fonctionnement, les vannes A4, A5, A6 sont configurées en mode fermé, les autres vannes étant en mode ouvert.

Dès lors une telle configuration des vannes implique alors que :
- le flux gazeux M8 de fluide cryogénique émanant de la source de fluide cryogénique 40 peut pénétrer dans le circuit de ce dispositif 7 d'analyse par RMN par l'élément de bouclage A2 ;
- le module de compression 10 et le troisième échangeur 17 sont isolés du reste du circuit par la fermeture des vannes A5 et A4, et
- le flux gazeux M4, récupéré en aval du rotor 31 et du stator 30 du porte-échantillon 12, est évacué du circuit vers l'environnement extérieur par l'élément de bouclage A3, car l'élément de bouclage A6 est en mode fermé.

Ainsi, les vannes A4, A5, A6 étant fermées et les éléments de bouclage A2, A3 étant ouvertes, le dispositif 7 d'analyse RMN est dans une configuration dans laquelle le circuit correspond à une double boucle ouverte. La réfrigération et la motorisation du porte-échantillon sont réalisées par cette double boucle ouverte.

Dans ce mode de fonctionnement, l'unité de stockage 41 de fluide haute pression est utilisée comme réserve susceptible de diffuser dans le circuit du dispositif le fluide gazeux qui y est stocké, en assurant le débit de ce fluide dans la boucle à la place du module de compression 10 chaud. Trois flux gazeux M1, M2, M3 haute pression provenant de cette unité de stockage 41 sont conduits vers le cryostat 8 afin de le traverser selon un processus de parcours du circuit du dispositif 7 d'analyse RMN sensiblement similaire à celui mis en oeuvre lors des premier et deuxième modes de fonctionnement.

Dans ce troisième mode de fonctionnement, les flux gazeux M5, M4 basse pression sont récupérés respectivement en sortie du stator 30 et rotor 31 du porte-échantillon 12 correspondant aux flux résultants des flux gazeux M1, M2, M3 haute pression. Ces flux gazeux M4, M5 forment un flux gazeux M6 qui est ensuite évacué par l'élément de bouclage A3 vers l'environnement extérieur sous la forme du fluide gazeux M9. Ainsi, le fluide gazeux est utilisé à perte jusqu'à ce que l'unité de stockage 41 en soit complètement vidée. Dans ce mode de fonctionnement, aucun flux gazeux ne traverse le cryoréfrigérateur 11 contrairement au premier et deuxième mode de fonctionnement.

Cependant, d'une manière sensiblement similaire aux premier et deuxième modes de fonctionnement, un transfert thermique 33 est réalisé dans le premier échangeur 18 de chaleur entre deux fluides, celui du flux gazeux M7 basse pression et des flux gazeux M1, M2, M3 haute pression. Ce transfert thermique 33 induit un refroidissement des flux gazeux M1, M2, M3 haute pression.

Dans ce troisième mode de fonctionnement, ce flux gazeux M7 correspond au flux gazeux M8 de fluide cryogénique qui provient de la source de fluide cryogénique 40 et qui pénètre dans le circuit de ce dispositif 7 d'analyse par RMN, par l'élément de bouclage A2. Ce flux gazeux M8 de fluide cryogénique à une température comprise entre 3 et 7K.

Par la suite, à la sortie du cryostat 8, après avoir traversé le premier échangeur 18, le flux gazeux M7 est évacué par l'élément de bouclage A1 vers l'environnement extérieur, puisque l'élément de bouclage A5 est en mode fermé. Ainsi, le flux gazeux M7 est utilisé à perte jusqu'à ce que la source de fluide cryogénique 40 en soit complètement vidée.

Ainsi que nous l'avons vu précédemment le quatrième mode de fonctionnement est mis en oeuvre par les deuxième et troisième modes de réalisation du dispositif 7.

Dans ce quatrième mode de fonctionnement, les vannes A6, A5, A8 sont configurées en mode fermé, les autres vannes du dispositif 7 sont en mode ouvert.

Dès lors une telle configuration des vannes implique alors que :
- le flux gazeux M8 de fluide cryogénique émanant de la source de fluide cryogénique 40 peut pénétrer dans le circuit de ce dispositif d'analyse par RMN par l'élément de bouclage A2, pour être évacué vers l'environnement 44 extérieur par l'élément de bouclage A1 ;
- le quatrième élément de canalisation 23 est isolé du reste du circuit par la fermeture des vannes A6 et A5, et
- le flux gazeux M9 résultant des flux gazeux M4, M5 basse pression récupérés respectivement en aval du rotor 31 et du stator 30 du porte-échantillon 12, est conduit vers le module de compression 10 en suivant le sixième élément de canalisation 26 en traversant l'élément de bouclage A3, car les vannes A6 et A8 sont en mode fermé.

Ainsi, les vannes A6, A5, A8 étant fermées et les autres vannes et/ou éléments de redirection, des deuxième et troisième modes de réalisation, ouvertes, le dispositif 7 d'analyse RMN est dans une configuration dans laquelle le circuit correspond à une double boucle fermé dans la partie haute pression et ouverte dans la partie basse pression du dispositif 7 d'analyse par RMN. La partie haute pression correspond aux éléments de canalisation 27, 20, 21, 22, compris entre le module de compression 10 et le porte-échantillon 12. La partie basse pression correspond au quatrième élément de canalisation 23 compris entre le porte-échantillon 12 et le module de compression 10.

La réfrigération et la motorisation du porte-échantillon sont réalisées par cette double boucle ouverte/fermée.

Dans ce mode de fonctionnement, le fluide gazeux M0 va subir une compression de la part du module de compression 10 qui définit le débit du fluide gazeux M0 dans ce circuit.

Ce fluide gazeux provenant du module de compression 10 est conduit vers le porte-échantillon 12 selon un processus de parcours du circuit du dispositif 7 d'analyse RMN sensiblement similaire à celui mis en oeuvre lors du premier mode de fonctionnement.

Dans le présent mode de fonctionnement, le flux gazeux M9, résultant des flux gazeux M4,M5 basse pression récupérés respectivement en aval du rotor 31 et du stator 30 du porte-échantillon 12, est conduit par le septième élément de canalisation 26 et l'élément de bouclage A3 vers le module de compression 10 chaud du fait notamment que les vannes A6,A8,A5 sont en mode fermé et l'élément de bouclage A7 en mode ouvert. Ce flux gazeux M9 gazeux subit une nouvelle compression avant d'être transmis au troisième échangeur 17, sous la forme d'un fluide gazeux M0 haute pression et de réaliser ainsi un nouveau cycle thermodynamique dans le circuit du dispositif d'analyse par RMN.

Par la suite, d'une manière similaire aux premier, deuxième et troisième modes de fonctionnement, un transfert thermique 33 est réalisé dans l'échangeur de chaleur 18 entre deux fluides, celui du flux gazeux M7 basse pression et des flux gazeux M1, M2, M3 haute pression. Ce transfert thermique 33 induit un refroidissement des flux gazeux M1, M2, M3 haute pression.

Dans ce quatrième mode de fonctionnement, ce flux gazeux M7 correspond au flux cryogénique M8 de fluide cryogénique, provenant de la source de fluide cryogénique 40, qui pénètre dans le circuit de ce dispositif 7 d'analyse par RMN, par l'élément de bouclage A2.

Ensuite, à la sortie du cryostat 8, après avoir traversé le premier échangeur 18, le flux gazeux M7 est évacué par l'élément de bouclage A1, puisque l'élément de bouclage A5 est en mode fermé. Ainsi, le flux gazeux M7 est utilisé à perte jusqu'à ce que la source de fluide cryogénique 10 en soit complètement vidée.

Dans un cinquième mode de fonctionnement, mis en oeuvre par le troisième mode de réalisation, les éléments de redirection VC1 à VC4 sont activés et les vannes A1, A2, A6 et A7 sont configurées en mode fermé.

Dès lors une telle configuration de ces vannes et éléments de redirection implique alors que :
- les flux gazeux M1, M2, M3 provenant de l'échangeur de chaleur 18 sont redirigés par l'élément de canalisation 29 vers l'entrée du cryoréfrigérateur 11 puis vers le premier échangeur 18, car les éléments de redirection VC1 à VC4 sont activés ;
- le flux gazeux M7 provenant du cryostat 8 est conduit au module de compression 10, car les vannes A1 et A7 sont fermées et l'élément de bouclage A5 est ouvert.

Ainsi, les éléments de redirection VC1 à VC4 étant activés et les vannes A1, A7 étant fermées, le dispositif 7 d'analyse par RMN est dans une configuration dans laquelle le circuit correspond à une boucle fermée autour du cryoréfrigérateur 11 et du premier échangeur 18 de chaleur. Lorsque les éléments de redirection VC1 à VC3 sont activés les flux gazeux M1, M2, M3, provenant respectivement des sorties f, g, h de l'échangeur de chaleur 18, sont redirigés vers l'entrée e du premier échangeur 18 de chaleur en passant par l'élément de canalisation 29.

En effet, ce mode de fonctionnement permet de réaliser un court-circuit en amont du cryoréfrigérateur 11, par l'activation des éléments de redirection VC1 à VC4 pour entretenir une circulation fluidique permanente et maintenir le cryostat 8 à basse température afin de conserver la puissance frigorifique instantanément disponible pour alimenter la sonde 9 d'analyse par RMN.

Ainsi, on remarquera qu'un avantage de ce mode de fonctionnement est de préserver de très basses températures cryogéniques dans le dispositif 7 d'analyse par RMN, notamment dans le cryoréfrigérateur 11 et dans la masse du premier échangeur 18, lorsque des manipulations doivent être opérées sur le dispositif 7, en particulier lors de changement d'échantillon ou lors de l'entretien de ce dispositif 7, en particulier lorsque la sonde 9 doit être séparée du cryostat 8.

Cela permet de redescendre en température en un temps très court.

Par ailleurs, dans les deuxième et troisième modes de réalisation, à la sortie du cryostat 8, les flux gazeux M1, M2, M3 haute pression refroidis sont conduits jusqu'à la sonde 9 d'analyse par RMN, à partir d'une ligne cryogénique 16. Cette ligne cryogénique 16 conduit également les flux gazeux M4, M5 par les vannes A3 ou A6 en fonction du mode de fonctionnement.

Le dispositif 7 comprend de plus une unité centrale, non représentée, qui comprend au moins un calculateur et des éléments matériel (hardware) et logiciel (software) pour mettre en oeuvre les étapes du procédé de fonctionnement du dispositif 7 d'analyse par RMN.

Cette unité centrale, à partir notamment du calculateur, est apte à mettre en oeuvre un programme d'ordinateur comprenant des instructions de code de programme pour l'exécution des étapes du procédé de fonctionnement tel que décrit précédemment.

Cette unité centrale est apte à contrôler les vannes A1 à A11 ainsi que les éléments de redirection VC1 à VC4 de sorte à définir différentes configurations de ces éléments en fonction des modes de fonctionnement à mettre en oeuvre.

Cette unité centrale comprend une interface homme machine qui permet de contrôler ces différents vannes A1 à A11 et des éléments de redirection VC1 à VC4 ainsi que de fixer des consignes de température et de vitesse de rotation du porte-échantillon 12. Le programme mettant en oeuvre les étapes du procédé de fonctionnement est également apte à exécuter une étape d'isolement de différentes parties du dispositif 7 d'analyse RMN telles que la sonde, les parties basse ou haute pression ou encore le module de compression et l'échangeur de chaleur.

Pour cela, l'unité centrale agit notamment sur des actionneurs commandant les vannes A1 à A11 et les éléments de redirection VC1 à VC4, en envoyant des commandes par des dispositifs de communication. En retour, elle reçoit des valeurs relatives à l'état de ces éléments, mode fermé ou mode ouvert, mesurées par des capteurs et transmises par les dispositifs de communication.

## Revendications

1. Procédé de fonctionnement d'un dispositif d'analyse (7) par RMN comprenant un circuit comportant :
- un module de compression (10), et
- une sonde (9) d'analyse RMN et un cryostat (8) reliés par une ligne cryogénique (16),
le cryostat comprenant un premier échangeur de chaleur (18) et un cryoréfrigérateur (11), le procédé comprenant une étape de configuration de ce circuit au travers duquel circule des flux de fluides (MO à M9), ladite étape de configuration comportant une mise en oeuvre de différents modes de fonctionnement du dispositif (7), en fonction de l'activation/désactivation d'éléments de redirection VC1, VC2, VC3, VC4 et/ou de la configuration en mode fermé/ouvert d'éléments de bouclage A1 à A11 de ce circuit, **caractérisé en ce que** le procédé comprend un mode de fonctionnement où les éléments de redirection sont activés et où les éléments de bouclage sont configurés de sorte que :
- le dispositif (7) d'analyse par RMN est dans une configuration dans laquelle le circuit correspond à une boucle fermée autour du cryoréfrigérateur (11) et du premier échangeur de chaleur (18),
- des flux gazeux (M1, M2, M3) provenant du premier échangeur de chaleur (18) sont redirigés par un élément de canalisation (29) vers une entrée du cryoréfrigérateur (11) puis vers le premier échangeur de chaleur (18),
- un flux gazeux (M7) provenant du cryostat (8) est conduit au module de compression (10),
afin de réaliser un court-circuit en amont du cryoréfrigérateur (11), par l'activation des éléments de redirection VC1, VC2, VC3, VC4 pour entretenir une circulation fluidique permanente et maintenir le cryostat (8) à basse température afin de conserver la puissance frigorifique instantanément disponible pour alimenter la sonde (9) d'analyse par RMN, l'échangeur de chaleur (18) étant muni d'au moins une première entrée (b), une deuxième entrée (e), une troisième entrée (c), une quatrième entrée (d), une première sortie (f) et une deuxième sortie (a), une troisième sortie (g) et une quatrième sortie (h), un compresseur (10) étant destiné à être disposé entre la première entrée (b) et la deuxième sortie (a), le cryostat (8) comprenant les éléments de redirection VC1, VC2, VC3, VC4 de la première sortie (f) sur la deuxième entrée (e) et des éléments de connexion d'une sonde d'analyse RMN entre la première sortie (f) et la deuxième entrée (e),
les éléments de redirection VC1, VC2, VC3 étant agencés en aval du premier échangeur (18) et l'élément de redirection VC4 étant agencé en aval du cryoréfrigérateur (11) et en amont du premier échangeur (18).

2. Procédé de fonctionnement selon la revendication précédente, **caractérisé en ce que** les différents modes de fonctionnement sont définis par différentes structures du circuit de circulation du fluide, notamment par des états ou configurations des différents éléments de bouclage A1 à A11 et/ou des différents éléments de redirection VC1, VC2, VC3, VC4.

3. Procédé de fonctionnement selon l'une quelconque des revendications précédentes, **caractérisé en ce qu'**il comprend une étape de mise en oeuvre d'au moins :
- un premier mode de fonctionnement ;
- un deuxième mode de fonctionnement ;
- un troisième mode de fonctionnement ; et
- un quatrième mode de fonctionnement, en plus du mode de fonctionnement défini dans la revendication 1.

4. Procédé de fonctionnement selon la revendication précédente, **caractérisé en ce que** l'étape de mise en oeuvre d'au moins un premier mode de fonctionnement du dispositif d'analyse (7) comprend une configuration en mode fermé d'un premier ensemble d'éléments de bouclage A1, A2, A3, A7 :
- l'élément de bouclage A1 se trouvant en aval de l'échangeur de chaleur (18) à l'extérieur du cryostat (8) et permettant de contrôler l'évacuation d'un flux gazeux vers un environnement extérieur en aval du premier échangeur (18),
- l'élément de bouclage A2 contrôlant l'introduction d'un flux gazeux de fluide cryogénique en amont de l'échangeur de chaleur (18) et en aval du cryoréfrigérateur (11),
- l'élément de bouclage A3 étant monté sur un élément de canalisation (26) et permettant de contrôler l'accès d'un flux gazeux à cet élément de canalisation (26),
- l'élément de bouclage A7 étant monté sur l'élément de canalisation (26) en aval de l'élément de bouclage A3 et en amont du module de compression (10) chaud.

5. Procédé de fonctionnement selon l'une quelconque des revendications 3 et 4, **caractérisé en ce que** l'étape de mise en oeuvre d'au moins un deuxième mode de fonctionnement du dispositif d'analyse (7) comprend une configuration en mode fermé d'un deuxième ensemble d'éléments de bouclage A2, A3, A4, A5 :
- l'élément de bouclage A2 contrôlant l'introduction d'un flux gazeux de fluide cryogénique en amont de l'échangeur de chaleur (18) et en aval du cryoréfrigérateur (11),
- l'élément de bouclage A3 étant monté sur un élément de canalisation (26) et permettant de contrôler l'accès d'un flux gazeux à cet élément de canalisation (26),
- l'élément de bouclage A4 étant monté sur un élément de canalisation (27) en aval d'un deuxième échangeur de chaleur (17) et en amont d'une unité de stockage (41) de fluide haute pression,
- l'élément de bouclage A5 étant monté sur un élément de canalisation (23) en aval de l'élément de bouclage A1 et en amont du module de compression (10) chaud.

6. Procédé de fonctionnement selon l'une quelconque des revendications 3 à 5, **caractérisé en ce que** l' étape de mise en oeuvre d'au moins un troisième mode de fonctionnement du dispositif d'analyse (7) comprend une configuration en mode fermé d'un troisième ensemble d'éléments de bouclage A4, A5, A6 :
- l'élément de bouclage A4 étant monté sur un élément de canalisation (27) en aval d'un deuxième échangeur de chaleur (17) et en amont d'une unité de stockage (41) de fluide haute pression,
- l'élément de bouclage A5 étant monté sur un élément de canalisation (23) en aval de l'élément de bouclage A1 et en amont du module de compression (10) chaud,
- l'élément de bouclage A6 étant monté sur l'élément de canalisation (23) en aval d'un porte-échantillon (12) la sonde (9) et en amont du cryoréfrigérateur (11).

7. Procédé de fonctionnement selon l'une des revendications 3 à 6, **caractérisé en ce que** l' étape de mise en oeuvre d'au moins un quatrième mode de fonctionnement du dispositif d'analyse (7) comprend une configuration en mode fermé d'un quatrième ensemble d'éléments de bouclage A6, A5, A8 :
- l'élément de bouclage A5 étant monté sur un élément de canalisation (23) en aval de l'élément de bouclage A1 et en amont du module de compression (10) chaud,
- l'élément de bouclage A6 étant monté sur l'élément de canalisation (23) en aval d'un porte-échantillon (12) la sonde (9) et en amont du cryoréfrigérateur (11),
- l'élément de bouclage A8 étant monté sur un élément de canalisation (26) en aval de l'élément de bouclage A3 et en amont de l'élément de bouclage A7.

8. Dispositif d'analyse (7) par RMN comprenant une sonde (9) d'analyse RMN et un cryostat (8) reliés par une ligne cryogénique (16), **caractérisé en ce qu'**il comprend des éléments matériels et/ou logiciels de mise en oeuvre du procédé de fonctionnement selon l'une des revendications précédentes, les éléments matériels et/ou logiciels comprenant des éléments de bouclage A1 à A11, le cryostat (8) comportant un échangeur de chaleur (18) muni d'au moins une première entrée (b), une deuxième entrée (e), une troisième entrée (c), une quatrième entrée (d), une première sortie (f), une deuxième sortie (a), une troisième sortie (g) et une quatrième sortie (h), un compresseur (10) étant destiné à être disposé entre la première entrée (b) et la deuxième sortie (a), le cryostat (8) comprenant des éléments de redirection VC1, VC2, VC3, VC4 de la première sortie (f) sur la deuxième entrée (e) et des éléments de connexion de la sonde d'analyse RMN entre la première sortie (f) et la deuxième entrée (e), les éléments de redirection VC1, VC2, VC3, VC4 comprenant des vannes à au moins deux voies, les éléments de bouclage A1 à A11 comprenant des vannes à deux voies et les éléments matériels et/ou logiciels comprenant une unité centrale susceptible de contrôler les éléments de bouclage A1 à A11 et les éléments de redirection VC1, VC2, VC3, VC4.

9. Dispositif d'analyse par RMN selon la revendication 8, **caractérisé en ce que** le cryostat comprend un cryoréfrigérateur (11) et un élément de canalisation (29) et est agencé de sorte à :
- former une boucle fermée autour du cryoréfrigérateur (11) et du premier échangeur de chaleur (18),
- rediriger, par un élément de canalisation (29), des flux gazeux (M1, M2, M3) provenant du premier échangeur de chaleur (18) vers une entrée du cryoréfrigérateur (11), puis vers le premier échangeur de chaleur (18).

## Patentansprüche

1. Verfahren zum Betrieb einer NMR-Analysevorrichtung (7), die einen Kreislauf beinhaltet, der Folgendes umfasst:
- ein Kompressionsmodul (10) und
- eine NMR-Analysesonde (9) und einen Kryostaten (8), die durch eine kryogene Leitung (16) miteinander verbunden sind,
wobei der Kryostat einen ersten Wärmetauscher (18) und einen Kryokühler (11) beinhaltet, wobei das Verfahren einen Schritt des Konfigurierens dieses Kreislaufs, durch den Fluidströme (MO bis M9) strömen, beinhaltet, wobei der Schritt des Konfigurierens eine Umsetzung unterschiedlicher Betriebsmodi der Vorrichtung (7) in Abhängigkeit von der Aktivierung/Deaktivierung von Umleitungselementen VC1, VC2, VC3, VC4 und/oder der Konfiguration in einem geschlossenen/offenen Modus von Schleifenbildungselementen A1 bis A11 dieses Kreislaufs umfasst, **dadurch gekennzeichnet, dass** das Verfahren einen Betriebsmodus beinhaltet, in dem die Umleitungselemente aktiviert sind und in dem die Schleifenbildungselemente so konfiguriert sind, dass:
- sich die NMR-Analysevorrichtung (7) in einer Konfiguration befindet, in der der Kreislauf einer geschlossenen Schleife um den Kryokühler (11) und den ersten Wärmetauscher (18) herum entspricht,
- von dem ersten Wärmetauscher (18) kommende Gasströme (M1, M2, M3) durch ein Kanalisierungselement (29) zu einem Einlass des Kryokühlers (11) und dann zu dem ersten Wärmetauscher (18) umgeleitet werden,
- ein von dem Kryostaten (8) kommender Gasstrom (M7) zu dem Kompressionsmodul (10) geleitet wird,
um durch die Aktivierung der Umleitungselemente VC1, VC2, VC3, VC4 stromaufwärts des Kryokühlers (11) eine Kurzschließung zu bewirken, um eine dauerhafte Fluidströmung aufrechtzuerhalten und den Kryostaten (8) auf einer tiefen Temperatur zu halten, um die sofort verfügbare Kühlleistung zur Versorgung der NMR-Analysesonde (9) zu bewahren,
wobei der Wärmetauscher (18) über mindestens einen ersten Einlass (b), einen zweiten Einlass (e), einen dritten Einlass (c), einen vierten Einlass (d), einen ersten Auslass (f) und einen zweiten Auslass (a), einen dritten Auslass (g) und einen vierten Auslass (h) verfügt, wobei ein Kompressor (10) dazu bestimmt ist, zwischen dem ersten Einlass (b) und dem zweiten Auslass (a) angeordnet zu sein, wobei der Kryostat (8) die Elemente zum Umleiten VC1, VC2, VC3, VC4 des ersten Auslasses (f) zu dem zweiten Einlass (e) und Elemente zum Verbinden einer NMR-Analysesonde zwischen dem ersten Auslass (f) und dem zweiten Einlass (e) beinhaltet,
wobei die Umleitungselemente VC1, VC2, VC3 stromabwärts des ersten Tauschers (18) und das Umleitungselement VC4 stromabwärts des Kryokühlers (11) und stromaufwärts des ersten Tauschers (18) eingerichtet sind.

2. Betriebsverfahren nach dem vorhergehenden Anspruch, **dadurch gekennzeichnet, dass** die unterschiedlichen Betriebsmodi durch unterschiedliche Strukturen des Fluidströmungskreislaufs definiert sind, insbesondere durch Zustände oder Konfigurationen der unterschiedlichen Schleifenbildungselemente A1 bis A11 und/oder der unterschiedlichen Umleitungselemente VC1, VC2, VC3, VC4.

3. Betriebsverfahren nach einem beliebigen der vorhergehenden Ansprüche, **dadurch gekennzeichnet, dass** es einen Schritt des Umsetzens mindestens von Folgendem beinhaltet:
- eines ersten Betriebsmodus;
- eines zweiten Betriebsmodus;
- eines dritten Betriebsmodus; und
- eines vierten Betriebsmodus, zusätzlich zu dem in Anspruch 1 definierten Betriebsmodus.

4. Betriebsverfahren nach dem vorhergehenden Anspruch, **dadurch gekennzeichnet, dass** der Schritt des Umsetzens mindestens eines ersten Betriebsmodus der Analysevorrichtung (7) eine Konfiguration in geschlossenem Modus eines ersten Satzes Schleifenbildungselemente A1, A2, A3, A7 beinhaltet:
- wobei sich das Schleifenbildungselement A1 stromabwärts des Wärmetauschers (18) außerhalb des Kryostaten (8) befindet und es gestattet, die Evakuierung eines Gasstroms zu einer äußeren Umgebung hin stromabwärts des ersten Tauschers (18) zu steuern,
- wobei das Schleifenbildungselement A2 die Einleitung eines Gasstroms kryogenen Fluids stromaufwärts des Wärmetauschers (18) und stromabwärts des Kryokühlers (11) steuert,
- wobei das Schleifenbildungselement A3 an einem Kanalisierungselement (26) montiert ist und es gestattet, den Zugang eines Gasstroms zu diesem Kanalisierungselement (26) zu steuern,
- wobei das Schleifenbildungselement A7 an dem Kanalisierungselement (26) stromabwärts des Schleifenbildungselements A3 und stromaufwärts des warmen Kompressionsmoduls (10) montiert ist.

5. Betriebsverfahren nach einem beliebigen der Ansprüche 3 und 4, **dadurch gekennzeichnet, dass** der Schritt des Umsetzens mindestens eines zweiten Betriebsmodus der Analysevorrichtung (7) eine Konfiguration in geschlossenem Modus eines zweiten Satzes Schleifenbildungselemente A2, A3, A4, A5 beinhaltet:
- wobei das Schleifenbildungselement A2 die Einleitung eines Gasstroms kryogenen Fluids stromaufwärts des Wärmetauschers (18) und stromabwärts des Kryokühlers (11) steuert,
- wobei das Schleifenbildungselement A3 an einem Kanalisierungselement (26) montiert ist und es gestattet, den Zugang eines Gasstroms zu diesem Kanalisierungselement (26) zu steuern,
- wobei das Schleifenbildungselement A4 an einem Kanalisierungselement (27) stromabwärts eines zweiten Wärmetauschers (17) und stromaufwärts einer Einheit zur Speicherung (41) eines Hochdruckfluids montiert ist,
- wobei das Schleifenbildungselement A5 an einem Kanalisierungselement (23) stromabwärts des Schleifenbildungselements A1 und stromaufwärts des warmen Kompressionsmoduls (10) montiert ist.

6. Betriebsverfahren nach einem beliebigen der Ansprüche 3 bis 5, **dadurch gekennzeichnet, dass** der Schritt des Umsetzens mindestens eines dritten Betriebsmodus der Analysevorrichtung (7) eine Konfiguration in geschlossenem Modus eines dritten Satzes Schleifenbildungselemente A4, A5, A6 beinhaltet:
- wobei das Schleifenbildungselement A4 an einem Kanalisierungselement (27) stromabwärts eines zweiten Wärmetauschers (17) und stromaufwärts einer Einheit zur Speicherung (41) eines Hochdruckfluids montiert ist,
- wobei das Schleifenbildungselement A5 an einem Kanalisierungselement (23) stromabwärts des Schleifenbildungselements A1 und stromaufwärts des warmen Kompressionsmoduls (10) montiert ist,
- wobei das Schleifenbildungselement A6 an dem Kanalisierungselement (23) stromabwärts eines Probenhalters (12) der Sonde (9) und stromaufwärts des Kryokühlers (11) montiert ist.

7. Betriebsverfahren nach einem der Ansprüche 3 bis 6, **dadurch gekennzeichnet, dass** der Schritt des Umsetzens mindestens eines vierten Betriebsmodus der Analysevorrichtung (7) eine Konfiguration in geschlossenem Modus eines vierten Satzes Schleifenbildungselemente A6, A5, A8 beinhaltet:
- wobei das Schleifenbildungselement A5 an einem Kanalisierungselement (23) stromabwärts des Schleifenbildungselements A1 und stromaufwärts des warmen Kompressionsmoduls (10) montiert ist,
- wobei das Schleifenbildungselement A6 an dem Kanalisierungselement (23) stromabwärts eines Probenhalters (12) der Sonde (9) und stromaufwärts des Kryokühlers (11) montiert ist,
- wobei das Schleifenbildungselement A8 an einem Kanalisierungselement (26) stromabwärts des Schleifenbildungselements A3 und stromaufwärts des Schleifenbildungselements A7 montiert ist.

8. NMR-Analysevorrichtung (7), beinhaltend eine NMR-Analysesonde (9) und einen Kryostaten (8), die durch eine kryogene Leitung (16) miteinander verbunden sind, **dadurch gekennzeichnet, dass** sie Hardware- und/oder Softwareelemente zur Umsetzung des Betriebsverfahrens nach einem der vorhergehenden Ansprüche beinhaltet, wobei die Hardware- und/oder Softwareelemente Schleifenbildungselemente A1 bis A11 beinhalten, wobei der Kryostat (8) einen Wärmetauscher (18) umfasst, der über mindestens einen ersten Einlass (b), einen zweiten Einlass (e), einen dritten Einlass (c), einen vierten Einlass (d), einen ersten Auslass (f), einen zweiten Auslass (a), einen dritten Auslass (g) und einen vierten Auslass (h) verfügt, wobei ein Kompressor (10) dazu bestimmt ist, zwischen dem ersten Einlass (b) und dem zweiten Auslass (a) angeordnet zu sein, wobei der Kryostat (8) Elemente zum Umleiten VC1, VC2, VC3, VC4 des ersten Auslasses (f) zu dem zweiten Einlass (e) und Elemente zum Verbinden der NMR-Analysesonde zwischen dem ersten Auslass (f) und dem zweiten Einlass (e) beinhaltet, wobei die Umleitungselemente VC1, VC2, VC3, VC4 Ventile mit mindestens zwei Wegen beinhalten, wobei die Schleifenbildungselemente A1 bis A11 Zweiwegeventile beinhalten und wobei die Hardware- und/oder Softwareelemente eine Zentraleinheit beinhalten, die dazu in der Lage ist, die Schleifenbildungselemente A1 bis A11 und die Umleitungselemente VC1, VC2, VC3, VC4 zu steuern.

9. NMR-Analysevorrichtung nach Anspruch 8, **dadurch gekennzeichnet, dass** der Kryostat einen Kryokühler (11) und ein Kanalisierungselement (29) beinhaltet und so eingerichtet ist, dass er:
- eine geschlossene Schleife um den Kryokühler (11) und den ersten Wärmetauscher (18) herum bildet,
- von dem ersten Wärmetauscher (18) kommende Gasströme (M1, M2, M3) durch ein Kanalisierungselement (29) zu einem Einlass des Kryokühlers (11) und dann zu dem ersten Wärmetauscher (18) umleitet.

## Claims

1. Method for operating an NMR analysis device (7) comprising a circuit comprising:
- a compression module (10),
- an NMR analysis probe (9) and a cryostat (8) linked by a cryogenic line (16),
the cryostat comprising a first exchanger (18) and a cryorefrigerator (11), the method comprising a step of configuration of this circuit through which fluid flows (M0 to M9) circulate, said configuration step comprising an implementation of different modes of operation of the device (7), according to the activation/deactivation of redirection elements VC1, VC2, VC3, VC4 and/or of the configuration in closed/open mode of looping elements A1 to A11 of this circuit,
wherein the method comprises a mode of operation where the redirection elements are activated and where the looping elements are configured such that :
- the NMR analysis device (7) is in a configuration in which the circuit corresponds to a closed loop around the cryorefrigerator (11) and the first heat exchanger (18),
- gas flows (M1, M2, M3) coming from the first heat exchanger (18) are redirected by a channelling element (29) to an inlet of the cryorefrigerator (11) and then to the first heat exchanger (18),
- a gas flow (M7) coming from the cryostat (8) is led to the compression module (10),
in order to realize a short circuit upstream of the cryorefrigerator (11), by activating the redirection elements VC1, VC2, VC3, VC4 to maintain a permanent fluidic circulation and to keep the cryostat (8) at a low temperature in order to keep the cooling power instantaneously available to feed the NMR analysis probe (9), the heat exchanger (18) being provided with at least a first inlet (b), a second inlet (e), a third inlet (c), a fourth inlet (d), a first outlet (f) and a second outlet (a), a third outlet (g) and a fourth outlet (h), a compressor (10) being intended to be arranged between the first inlet (b) and the second outlet (a), the cryostat (8) comprising redirection elements VC1, VC2, VC3, VC4 from the first outlet (f) to the second inlet (e) and connection elements for an NMR analysis probe between the first outlet (f) and the second inlet (e),
the redirection elements VC1, VC2, VC3 being arranged downstream of the first exchanger (18) and the redirection element VC4 being arranged downstream of the cryorefrigerator (11) and upstream of the first exchanger (18).

2. Operating method according to the preceding claim, **characterized in that** the different modes of operation are defined by different structures of the fluid circulation circuit, notably by states or configurations of the different looping elements A1 to A11 and/or of the different redirection elements VC1, VC2, VC3, VC4.

3. Operating method according to any one of the preceding claims, **characterized in that** it comprises a step of implementation of at least:
- first mode of operation;
- one second mode of operation;
- one third mode of operation; and
- one fourth mode of operation, in addition to the mode of operation defined in claim 1.

4. Operating method according to the preceding claim, **characterized in that** the step of implementation of at least one first mode of operation of the analysis device (7) comprises a configuration in closed mode of a first set of looping elements A1, A2, A3, A7:
- the looping element A1 being located downstream of the heat exchanger (18) outside the cryostat (8) and allowing to control the evacuation of a gas flow towards an external environment downstream of the first exchanger (18),
- the looping element A2 controlling the introduction of a gas flow of cryogenic fluid upstream of the heat exchanger (18) and downstream of the cryorefrigerator (11),
- the looping member A3 being mounted on a channelling element (26) and controlling access of a gas flow to the channelling element (26),
- the looping element A7 being mounted on the channelling element (26) downstream of the looping element A3 and upstream of the hot compression module (10).

5. Operating method according to either one of claims 3 and 4, **characterized in that** the step of implementation of at least one second mode of operation of the analysis device (7) comprises a configuration in closed mode of a second set of looping elements A2, A3, A4, A5:
- the looping element A2 controlling the introduction of a gas flow of cryogenic fluid upstream of the heat exchanger (18) and downstream of the cryorefrigerator (11),
- the looping member A3 being mounted on a channelling element (26) and controlling access of a gas flow to the channelling element (26),
- the looping element A4 being mounted on a channelling element (27) downstream of a second heat exchanger (17) and upstream of a highpressure fluid storage unit (41),
- the looping element A5 being mounted on a channelling element (23) downstream of the looping element A1 and upstream of the hot compression module (10).

6. Operating method according to any one of Claims 3 to 5, **characterized in that** the step of implementation of at least one third mode of operation of the analysis device (7) comprises a configuration in closed mode of a third set of looping elements A4, A5, A6:
- the looping element A4 being mounted on a channelling element (27) downstream of a second heat exchanger (17) and upstream of a highpressure fluid storage unit (41),
- the looping element A5 being mounted on a channelling element (23) downstream of the looping element A1 and upstream of the hot compression module (10),
- the looping element A6 being mounted on the channelling element (23) downstream of a sample-holder (12) of the probe (9) and upstream of the cryorefrigerator (11).

7. Operating method according to one of Claims 3 to 6, **characterized in that** the step of implementation of at least one fourth mode of operation of the analysis device (7) comprises a configuration in closed mode of a fourth set of looping elements (A6, A5, A8):
- the looping element A5 being mounted on a channelling element (23) downstream of the looping element A1 and upstream of the hot compression module (10),
- the looping element A6 being mounted on the channelling element (23) downstream of a sample-holder (12) of the probe (9) and upstream of the cryorefrigerator (11),
- the looping element A8 being mounted on a channelling element (26) downstream of the looping element A3 and upstream of the looping element A7.

8. NMR analysis device (7) comprising an NMR analysis probe (9) and a cryostat (8) linked by a cryogenic line (16), **characterized in that** it comprises hardware and/or software elements for implementing the operating method according to one of the preceding claims, hardware and/or software elements comprising looping elements A1 to A11, the cryostat (8) comprising a heat exchanger (18) provided with at least one first inlet (b), one second inlet (e), one third inlet (c), one fourth inlet (d), one first outlet (f) and one second outlet (a), one third outlet (g) and one fourth outlet (h), a compressor (10) being intended to be arranged between the first inlet (b) and the second outlet (a), the cryostat (8) comprising redirection elements VC1, VC2, VC3, VC4 from the first outlet (f) to the second inlet (e) and connection elements of the NMR analysis probe between the first outlet (f) and the second inlet (e), the redirection elements VC1, VC2, VC3, VC4 comprising at least two-way valves, the looping elements A1 to A11 comprising two-way valves and the hardware and/or software elements comprising a central unit capable of controlling the looping elements A1 to A11 and the redirection elements VC1, VC2, VC3, VC4.

9. NMR analysis device (7) according to claim 8, **characterized in that** the cryostat comprises a cryorefrigerator (11) and a channelling element (29) and is arranged to :
- form a closed loop around the cryorefrigerator (11) and the first heat exchanger (18),
- redirecting, through a channeling element (29), gas flows (M1, M2, M3) coming from the first heat exchanger (18) to an inlet of the cryorefrigerator (11) and then to the first heat exchanger (18).
